# EUROPÄISCHE PATENTSCHRIFT

(11) **EP 0 793 698 B1**
(45) Veröffentlichungstag und Bekanntmachung des Hinweises auf die Patenterteilung: **29.03.2000**
(21) Anmeldenummer: 95938459.5
(22) Anmeldetag: 22.11.1995
(51) Int. Cl.: C09K 11/06, C08G 61/00

(54) **KONJUGIERTE POLYMERE MIT HETERO-SPIROATOMEN UND IHRE VERWENDUNG ALS ELEKTROLUMINESZENZMATERIALIEN**
CONJUGATED POLYMERS WITH HETERO-SPIROATOMS AND THE USE OF SUCH POLYMERS AS ELECTROLUMINESCENT MATERIALS
POLYMERES CONJUGUES CONTENANT DES HETERO-SPIRO-ATOMES ET LEUR UTILISATION SOUS FORME DE MATERIAUX ELECTROLUMINESCENTS

(30) Priorität: 25.11.1994 DE 4442052
(43) Veröffentlichungstag der Anmeldung: 10.09.1997
(73) Patentinhaber: Aventis Research & Technologies GmbH & Co. KG, 65926 Frankfurt am Main (DE)
(72) Erfinder: KREUDER, Willi, D-55126 Mainz (DE); LUPO, Donald, D-60316 Frankfurt am Main (DE); SALBECK, Josef, D-65779 Kelkheim (DE); SCHENK, Hermann, D-65719 Hofheim (DE); STEHLIN, Thomas, D-65830 Kriftel (DE)
(86) Internationale Anmeldenummer: EP9504594
(87) Internationale Veröffentlichungsnummer: WO9617036

(56) Entgegenhaltungen:
- EP-A- 0 259 229
- JOURNAL OF THE CHEMICAL SOCIETY. FARADAY TRANSACTIONS, Bd. 90, Nr. 2, 21.Januar 1994, Seiten 321-325, XP000424514 JUNZO MATSUDA ET AL: "ELECTROCHEMICAL SYNTHESIS OF SOLUBLE POLY(9-HEXYFLUORENE AND POLY(1-HEXYLINDENE)"

## Beschreibung

Es besteht ein hoher industrieller Bedarf an großflächigen Festkörper-Lichtquellen für eine Reihe von Anwendungen, überwiegend im Bereich von Anzeigeelementen, der Bildschirmtechnologie und der Beleuchtungstechnik. Die an diese Lichtquellen gestellten Anforderungen können zur Zeit von keiner der bestehenden Technologien völlig befriedigend gelöst werden.

Als Alternative zu herkömmlichen Anzeige- und Beleuchtungselementen, wie Glühlampen, Gasentladungslampen und nicht selbstleuchtenden Flüssigkristallanzeigeelementen, sind bereits seit einiger Zeit Elektrolumineszenz(EL)materialien und -vorrichtungen, wie lichtemittierende Dioden (LED), in Gebrauch.

Neben anorganischen sind seit etwa 30 Jahren auch niedermolekulare organische Elektrolumineszenzmaterialien und -vorrichtungen bekannt (siehe z.B. US-A-3,172,862). Bis vor kurzem waren aber solche Vorrichtungen in ihrer praktischen Verwendbarkeit stark eingeschränkt.

In WO 90/13148 und EP-A-0,443,861 sind Elektrolumineszenzvorrichtungen beschrieben, die einen Film aus einem konjugierten Polymer als lichtemittierende Schicht (Halbleiterschicht) enthalten. Solche Vorrichtungen bieten zahlreiche Vorteile wie die Möglichkeit, großflächige, flexible Displays einfach und kostengünstig herzustellen. Im Gegensatz zu Flüssigkristalldisplays sind Elektrolumineszenzdisplays selbstleuchtend und benötigen daher keine zusätzliche rückwärtige Beleuchtungsquelle.

Eine typische Vorrichtung nach WO 90/13148 besteht aus einer lichtemittierenden Schicht in Form eines dünnen, dichten Polymerfilms (Halbleiterschicht), der wenigstens ein konjugiertes Polymer enthält. Eine erste Kontaktschicht steht in Kontakt mit einer ersten Oberfläche, eine zweite Kontaktschicht mit einer weiteren Oberfläche der Halbleiterschicht. Der Polymerfilm der Halbleiterschicht hat eine genügend geringe Konzentration von extrinsischen Ladungsträgern, so daß beim Anlegen eines elektrischen Feldes zwischen den beiden Kontaktschichten Ladungsträger in die Halbleiterschicht eingebracht werden, wobei die eine Kontaktschicht positiv gegenüber der anderen wird, und die Halbleiterschicht Strahlung aussendet. Die in solchen Vorrichtungen verwendeten Polymere sind konjugiert. Unter konjugiertem Polymer versteht man ein Polymer, das ein delokalisiertes Elektronensystem entlang der Hauptkette besitzt. Das delokalisierte Elektronensystem verleiht dem Polymer Halbleitereigenschaften und gibt ihm die Möglichkeit, positive und/oder negative Ladungsträger mit hoher Mobilität zu transportieren.

In WO 90/13148 wird als polymeres Material für die lichtemittierende Schicht Poly(p-phenylenvinylen) verwendet, und es wird vorgeschlagen, die Phenylgruppe in einem solchen Material durch ein heterocyclisches oder ein kondensiertes carbocyclisches Ringsystem zu ersetzen. Daneben wird auch Poly(p-phenylen), PPP, als elektrolumineszierendes Material verwendet.

Obwohl mit diesen Materialien gute Ergebnisse erzielt wurden, ist beispielsweise die Farbreinheit noch unbefriedigend. Weiterhin ist es mit den bisher bekannten Polymeren kaum möglich, eine blaue oder weiße Emission zu erzeugen.

Da zudem die Entwicklung von Elektrolumineszenzmaterialien, insbesondere auf Grundlage von Polymeren, noch in keiner Weise als abgeschlossen betrachtet werden kann, sind die Hersteller von Beleuchtungs- und Anzeigevorrichtungen an den unterschiedlichsten Elektrolumineszenzmaterialien für solche Vorrichtungen interessiert.

Dies liegt unter anderem auch daran, weil erst das Zusammenwirken der Elektrolumineszenzmaterialien mit den weiteren Bauteilen der Vorrichtungen Rückschlüsse auf die Qualität auch des Elektrolumineszenzmaterials zuläßt.

Aufgabe der vorliegenden Erfindung war es daher, neue Elektrolumineszenzmaterialien bereitzustellen, die bei Verwendung in Beleuchtungs- oder Anzeigevorrichtung geeignet sind, das Eigenschaftsprofil dieser Vorrichtungen zu verbessern.

Es wurde nun überraschend gefunden, daß konjugierte Polymere, die mindestens eine Wiederholeinheit auf Basis eines Heterospirogerüsts enthalten, neben einer hervorragenden Thermostabilität, verbesserten Löslichkeit in organischen Solventien und verbesserten Filmbildungseigenschaften insbesondere auch gute Elektro- und Photolumineszenz mit einer hohen Farbreinheit aufweisen.

Spiroverbindungen sind Verbindungen in denen zwei Ringsysteme durch ein einziges, vierbindiges Atom verknüpft sind. Dieses Atom wird als Spiroatom bezeichnet, wie in Handbook of Chemistry and Physics 62^{nd} ed. (1981-2), CRC Press, Seite C-23 bis C-25 ausgeführt.

Verbindungen, bei denen zwei Polymere über ein einziges Spirozentrum verknüpft sind, sind beispielsweise in US-A 5,026,894 und bei J. M. Tour et al., J. Am. Chem. Soc. 1990, 112, 5662; J. M. Tour et al., J. Am. Chem. Soc. 1994, 113, 7064 und J. M. Tour et al., Polym. Prepr. 1990, 408 als Materialien für molekulare Elektronik vorgeschlagen. Eine mögliche Eignung solcher Verbindungen als Elektrolumineszenzmaterialien lä8t sich daraus nicht ableiten.

Gegenstand der Erfindung sind daher konjugierte Polymere, enthaltend Wiederholeinheiten der Formel (I), wie sie in Anspruch 1 beschrieben werden.

Bevorzugt sind konjugierte Polymere, enthaltend Wiederholeinheiten der Formel (II), wie sie in Anspruch 3 beschrieben werden.
Die erfindungsgemäßen Polymere der Formel (I) und (II) zeichnen sich insbesondere durch eine hohe Farbreinheit der Emission aus.

Polymer bedeutet im Sinne der Erfindung eine Verbindung, deren Elektrolumineszenzspektrum bei Anfügen weiterer Wiederholeinheiten im wesentlichen gleich bleibt.

Die erfindungsgemäßen Polymere der Formel (I) und (II) weisen im allgemeinen 2 bis 1000, vorzugsweise 2 bis 500, besonders bevorzugt 2 bis 100, Wiederholeinheiten auf.

Bevorzugt sind weiterhin solche Polymere der allgemeinen Formel (II), bei denen die Symbole und Indizes folgende Bedeutungen haben:
- A: ist gleich oder verschieden R¹, R², R³ und/oder R⁴;
- Q, K: sind gleich oder verschieden konjugierte C₂ bis C₁₀₀ Kohlenwasserstoffreste, insbesondere 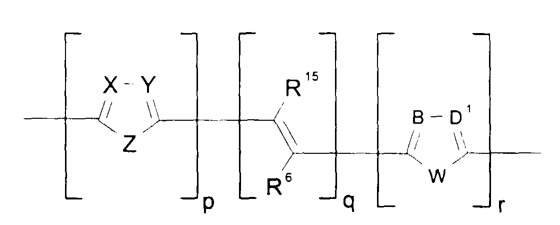 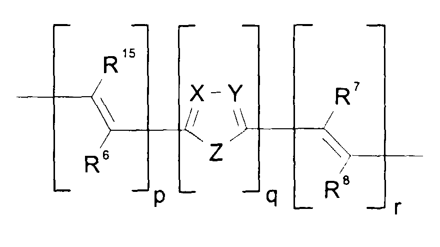 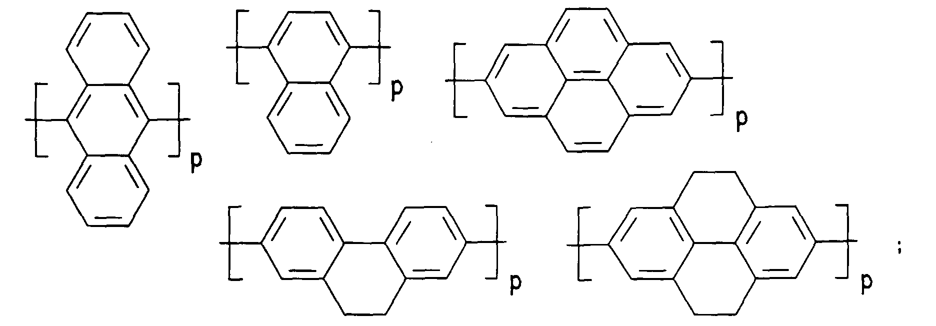
- X, Y, B, D¹: sind gleich oder verschieden CR⁵, N;
- Z, W: sind gleich oder verschieden -O-, -S-, -NR⁵-, -CR⁵R⁶-, -CR⁵=CR⁶-, -CR⁵=N-;
- p, q, r: sind gleich oder verschieden 0, 1 bis 5;
- R¹, R², R³, R⁴, R⁵, R⁶, R⁷, R⁸, R¹⁵: sind gleich oder verschieden H, eine geradkettige oder verzweigte Alkyl, Alkoxy oder Estergruppe mit 1 bis 22 C-Atomen, Aryl- und/oder Aryloxygruppen, vorzugsweise Phenyl- und/oder Phenyloxygruppen, wobei der Aromat mit C₁-C₂₂-Alkyl, C₁-C₂₂-Alkoxy, Br, Cl, F, CN, und/oder NO₂ substituiert sein kann, Br, Cl, F, CN, NO₂, CF₃;
- L, M: sind gleich oder verschieden 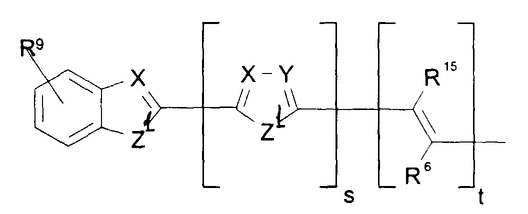 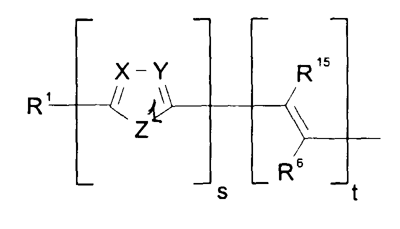 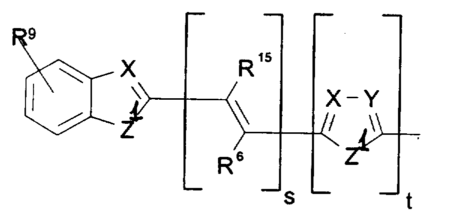 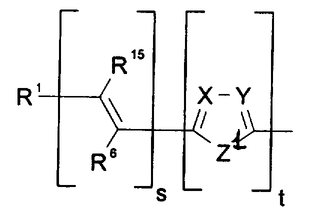 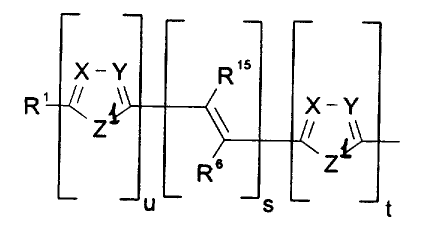 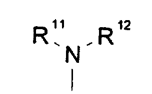 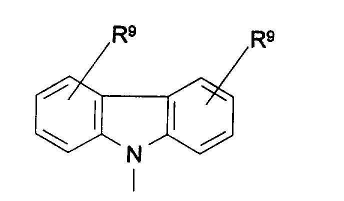
- R⁹: ist gleich oder verschieden H, eine unverzweigte oder verzweigte Alkyl- oder Alkoxygruppe mit 1 bis 22 Kohlenstoffatomen, -CN, -NO₂, -NR¹¹R¹², Phenyl, Biphenyl, 1-Naphthyl, 2-Naphthyl, 2-Thienyl, 2-Furanyl, wobei Aryle und Heteroaryle einen weiteren Substituenten R⁹ tragen können;
- X, Y: sind gleich oder verschieden =CR⁵-, =N-;
- Z¹: ist gleich oder verschieden -O-, -S-, -NR¹¹-, CR⁵R⁶, -CR⁵=CR⁶-, -CR⁵=N-;
- R¹¹, R¹²: sind gleich oder verschieden H, eine unverzweigte oder verzweigte Alkylgruppe mit 1 bis 22 Kohlenstoffatomen, Phenyl, 3-Methylphenyl, Biphenyl, 1-Naphthyl, 2-Naphthyl,

Besonders bevorzugt sind Verbindungen der Formel (II), bei denen gilt:
- Q, K: sind gleich oder verschieden 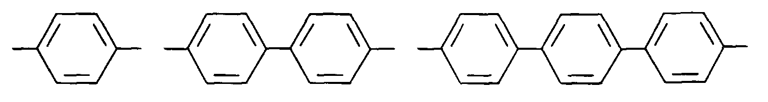 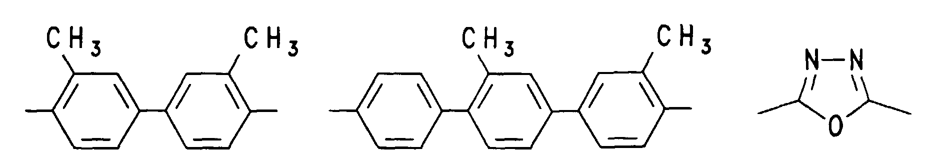 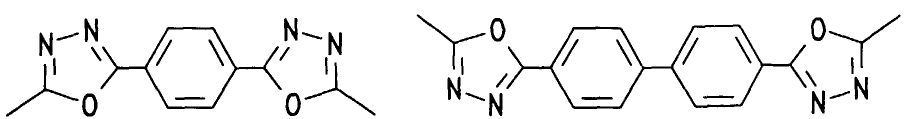 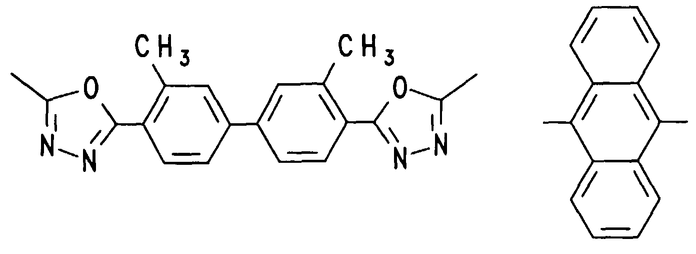
- m, n: sind gleich oder verschieden 0 oder 1;
- L, M: sind gleich oder verschieden 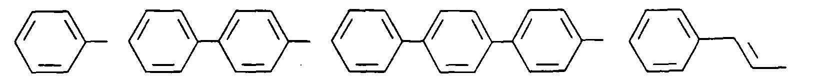 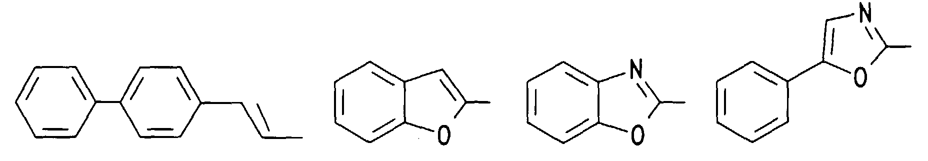 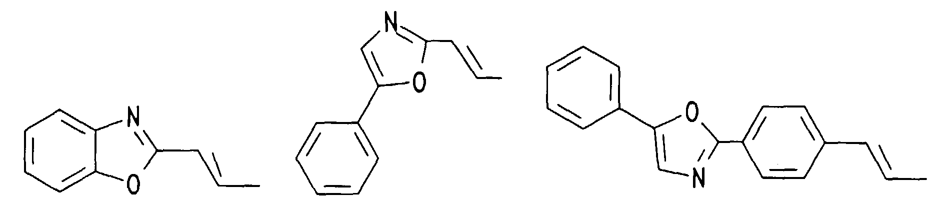 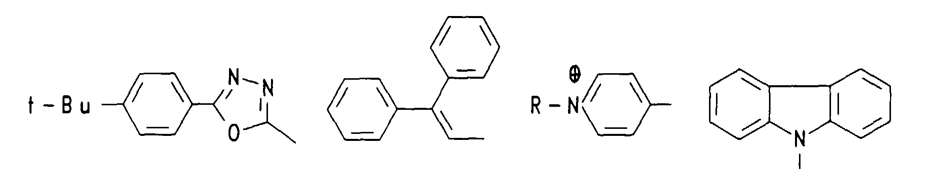
- R =: C₁-C₂₂ Alkyl, C₂H₄SO₃⁻ 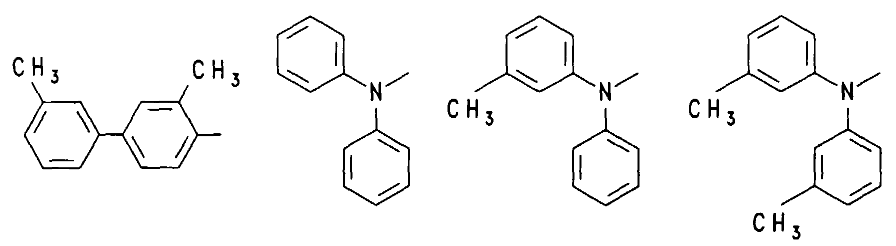 Ganz besonders bevorzugt sind Verbindungen der Formel (II), bei denen gilt
- Q, K: sind gleich oder verschieden 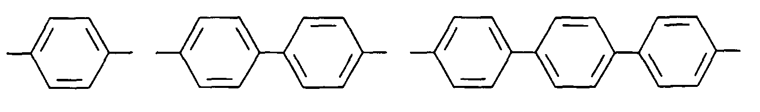 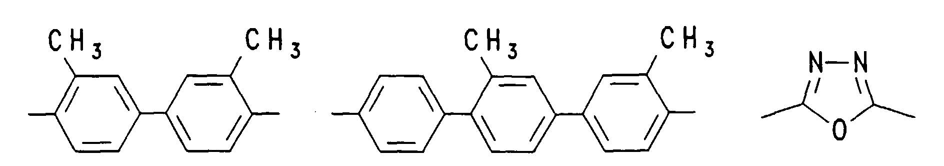 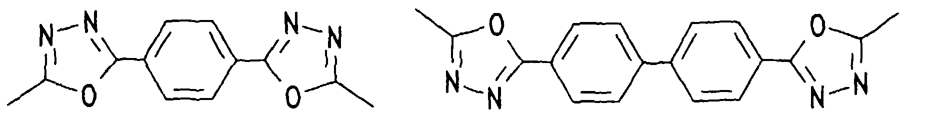 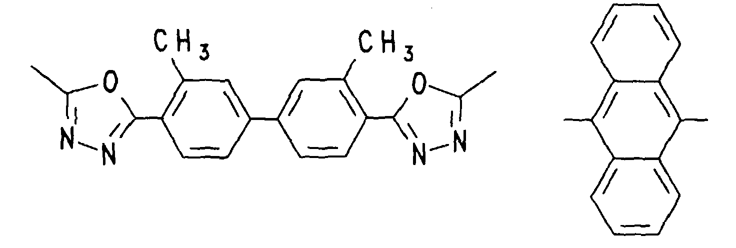 m + n ist 0 oder 1;
- L, M: sind gleich oder verschieden

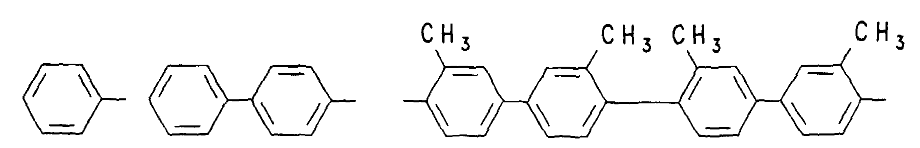

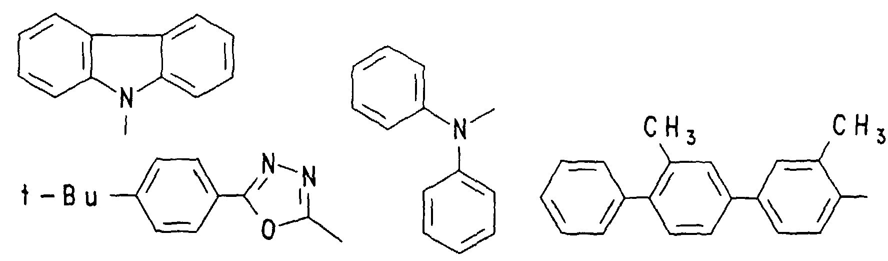

Für einige Anwendungen kann es vorteilhaft sein, eines, mehrere oder alle Wasserstoffatome, bevorzugt solche an aromatischen Ringen, durch F-Atome zu ersetzen.

Die erfindungsgemäßen Verbindungen der Formel (I) sind Homo- oder Copolymere, d.h., daß die Verbindungen der Formel (I) auch unterschiedliche Wiederholeinheiten aufweisen können.

Die erfindungsgemäßen Polymere der Formel (I) zeichnen sich weiterhin durch eine beträchtliche Steigerung der Löslichkeit in organischen Solventien und gute Filmbildungseigenschaften aus. Dadurch wird die Herstellung von Elektrolumineszenzvorrichtungen erleichtert und ihre Lebensdauer erhöht. Darüber hinaus erlaubt die kovalent gebundene Anordnung der Substituenten über die Spiroatome, senkrecht zur konjugierten Hauptkette, einen molekularen Aufbau in der Weise, daß ohne Störung der Konjugation in der Hauptkette bestimmte Eigenschaften eingestellt werden können. So kann die Polymerkette z.B. Ladungstransport- oder Ladungsinjektionseigenschaften besitzen, während die Substituenten lichtemittierende Eigenschaften besitzen. Die Emissionseigenschaften der erfindungsgemäß eingesetzten Verbindungen können durch die Wahl geeigneter Substituenten über den ganzen Bereich des sichtbaren Spektrums eingestellt werden. Die durch die kovalente Anknüpfung fixierte räumliche Nähe der beiden Hälften ist dabei günstig für die Energieübertragung (siehe z.B. B. Liphardt, W.Lüttke Liebigs Ann. Chem. 1981, 1118).

Die erfindungsgemäßen Verbindungen der Formel (I) sind zur Erzielung blauer Elektrolumineszenz gut geeignet.

Die Herstellung der erfindungsgemäßen Polymere kann nach an sich literaturbekannten Methoden, wie sie in Standardwerken zur Organischen Synthese, z.B. Houben-Weyl, Methoden der Organischen Chemie, Georg-Thieme-Verlag, Stuttgart und in den Bänden der Serie "The Chemistry of Heterocyclic Compounds, A. Weissberger, E. C. Taylor (eds.), insbesondere Band 13/5, S. 30-87, beschrieben werden, erfolgen.

Die Herstellung erfolgt dabei unter Reaktionsbedingungen, die für die genannten Umsetzungen bekannt und geeignet sind. Dabei kann auch von an sich bekannten, hier nicht näher erwähnten Varianten Gebrauch gemacht werden.

Als Ausgangsverbindungen für die Herstellung der erfindungsgemäßen Polymere kommen bevorzugt Monomere mit einem 9,9'-Spirobi-9-stanna-bifluoren, 9,9'-Spirobi-9-germa-bifluoren und besonders bevorzugt 9,9'-Spirobi-9-silafluoren-Baustein zum Einsatz, die in 2,7- bzw. gegebenenfalls 2',7'-Position substituiert sind.

Eine Methode zur Synthese dieser Monomeren beruht z.B. auf der Synthese des 9,9'-Spirobi-9-silafluorens, z.B. aus 2,2'-Dibrombiphenyl und Siliciumtetrachlorid hber 2,2'-Dilithiobiphenyl, wie sie von H. Gilman und R. D. Gorsich, J. Am. Chem. Soc. 1958, 80, S. 1883 beschrieben ist, welches anschließend weiter in geeigneter Weise substituiert wird.
Möglichkeiten zur Funktionalisierungen des Kohlenstoff-Analogen 9,9'-Spirobifluoren sind beschrieben in J.H. Weisburger, E.K. Weisburger,
F.E. Ray, J. Am. Chem. Soc. 1959, 72, 4253; F. K. Sutcliffe, H.M. Shahidi, D. Paterson, J. Soc. Dyers Colour 1978, 94, 306; und G. Haas, V. Prelog, Helv. Chim. Acta 1969, 52, 1202; sie sind auch zur Funktionalisierung der erfindungsgemäßen Heterospiroverbindungen geeignet.

Es kann von Vorteil sein das gewünschte Substitutionsmuster des monomeren 9,9'-Spirobi-9-silafluoren durch Spiroverknüpfung von bereits geeignet substituierten Edukten zu erreichen, z.B. mit 2,7-difunktionalisierten 9,9-Dichlor-9-sila-fluoren, und die noch freien 2',7'-Positionen nach Aufbau des Spirozentrums dann gegebenenfalls weiter zu funktionalisieren (z.B. durch Halogenierung oder Acylierung, mit anschlie8ender C-C-Verknüpfung nach Umwandlung der Acetylgruppen in Aldehydgruppen, oder durch Heterocyclenaufbau nach Umwandlung der Acetylgruppen in Carbonsäuregruppen).

Die weitere Funktionalisierung kann nach an sich literaturbekannten Methoden erfolgen, wie sie in Standardwerken zur Organischen Synthese, z.B Houben-Weyl, Methoden der Organischen Chemie, Georg-Thieme Verlag, Stuttgart und in den entsprechenden Bänden der Serie "The Chemistry of Heterocyclic Compounds" von A. Weissberger und E.C. Taylor (Herausgeber) beschrieben werden.

Für die Synthese der Gruppen Q, K, L, M sei beispielsweise verwiesen auf DE-A-23 44 732, 24 50 088, 24 29 093, 25 02 904, 26 36 684, 27 01 591 und 27 52 975 für Verbindungen mit 1,4-Phenylen-Gruppen DE-A 26 41 724 für Verbindungen mit Pyrimidin-2,5-diyl-Gruppen; DE-A 40 26 223 und EP-A-0 391 203 für Verbindungen mit Pyridin-2,5-diyl-Gruppen; DE-A 32 31 462 für Verbindungen mit Pyridazin-3,6-diyl-Gruppen; N. Miyaura, T. Yanagi und A. Suzuki in Synthetic Communications 1981, 11, 513 bis 519, DE-C-3 930 663, M. J. Sharp, W. Cheng, V. Snieckus in Tetrahedron Letters 1987, 28, 5093; G. W. Gray in J.Chem.Soc. Perkin Trans II 1989, 2041 und Mol. Cryst. Liq. Cryst. 1989, 172, 165, Mol. Cryst. Liq. Cryst. 1991, 204, 43 und 91; EP-A 0 449 015; WO 89/12039; WO 89/03821; EP-A 0 354 434 für die direkte Verknüpfung von Aromaten und Heteroaromaten.

Die Herstellung disubstituierter Pyridine, disubstituierter Pyrazine, disubstituierter Pyrimidine und disubstituierter Pyridazine findet sich beispielsweise in den entsprechenden Bänden der Serie "The Chemistry of Heterocyclic Compounds" von A. Weissberger und E.C. Taylor (Herausgeber).

Ausgehend von den oben angegebenen Monomeren ist die Polymerisation zu den erfindungsgemäßen Polymeren der Formel (I) nach mehreren Methoden möglich.

Beispielsweise können Derivate des 9,9'-Spirobi-9-silafluorens oxidativ (z.B. mit FeCl₃, siehe u.a. P. Kovacic, N. B. Jones, Chem. Ber. 1987, 87, 357 bis 379; M. Weda, T. Abe, H. Awano, Macromolecules 1992, 25, 5125) oder elektrochemisch (siehe z.B. N. Saito, T. Kanbara, T. Sato, T. Yamamoto, Polym. Bull. 1993, 30, 285) polymerisiert werden.

Ebenso können die erfindungsgemäßen Polymere der Formel (I) aus 2,7-difunktionalisierten 9,9'-Spirobi-9-silafluoren-Derivaten hergestellt werden.
Dihalogenaromaten lassen sich unter Kupfer/Triphenylphosphan- (siehe z.B. G. W. Ebert, R. D. Rieke, J. Org. Chem. 1988, 53, 44829) oder Nickel/Triphenylphosphan-Katalyse (siehe z.B. H. Matsumoto, S. Inaba, R. D. Rieke, J. Org. Chem. 1983, 48, 840) polymerisieren.

Aromatische Diboronsäuren und aromatische Dihalogenide oder gemischte aromatische Halogen-Boronsäuren lassen sich unter Palladiumkatalyse durch Kupplungsreaktionen polymerisieren (siehe z.B. M. Miyaura, T. Yanagi, A. Suzuki, Synth. Commun. 1981, 11, 513; R. B. Miller, S. Dugar, Organometallics 1984, 3, 1261).
Aromatische Distannane lassen sich z.B., wie bei J. K. Stille, Angew. Chem. Int. Ed. Engl. 1986, 25, 508 angegeben, unter Palladiumkatalyse polymerisieren.

Weiterhin können die oben erwähnten Dibromverbindungen in die Dilithio- oder Digrignardverbindungen übergefhhrt werden, die dann mit weiterer Dibromverbindung mittels CuCl₂ (siehe z.B. G. Wittig, G. Klar, Liebigs Ann. Chem. 1967, 704, 91; H. A. Staab, F. Bunny, Chem. Ber. 1967, 100, 293; T. Kaufmann, Angew. Chem. 1974, 86, 321 bis 354) oder durch Elektronentransfer ungesättigter 1,4-Dihalogenverbindungen (siehe z.B. S. K. Taylor, S. G. Bennett, K. J. Harz, L. K. Lashley, J. Org. Chem. 1981, 46, 2190) polymerisiert werden.

Die Synthese der erfindungsgemäßen Polymeren der Formel (I) kann aber auch durch Polymerisation eines 2,7-difunktionalisierten 9,9'-Spirobi-9-silafluorenderivates mit einer weiteren, geeignet difunktionalisierten Verbindung erfolgen.

So kann z.B. 2,7-Dibrom-9,9'-spirobi-9-sila-fluoren mit Biphenyl-4,4'-bisboronsäure polymerisiert werden. Auf diese Weise ist gleichzeitig mit dem Polymerisationsschritt der Aufbau verschiedener heterocyclischer Einheiten möglich, z.B. die Bildung von Oxadiazoleinheiten aus difunktionellen Carbonsäurehalogeniden und difunktionellen Carbonsäurehydraziden oder aus der entsprechenden Dicarbonsäure und Hydrazinsulfat (B. Schulz, E. Leibnitz, Acta Polymer. 1992, 43, Seite 343; JP-A 05/178, 990, oder alternativ aus Dicarbonsäurehalogeniden und Bistetrazolen (C. A. Abshire, C. S. Marvel, Makromol. Chem. 1961, 44 bis 46, Seite 388).

Zur Herstellung von Copolymeren können beispielsweise unterschiedliche Verbindung der Formel (I) gemeinsam polymerisiert werden.

Die Aufarbeitung erfolgt nach bekannten, dem Fachmann geläufigen Methoden, wie sie beispielsweise bei R. J. Young, P. A. Lovell, Introduction to Polymers, Chapman & Hall, London, 1991, beschrieben sind. Beispielsweise kann man die Reaktionsmischung filtrieren, mit wäßriger Säure verdünnen, extrahieren und das nach Trocknen und Abziehen des Lösungsmittels erhaltene Rohprodukt durch Umfällen weiter reinigen.

Endständige Bromatome können beispielsweise mit LiAlH₄ reduktiv entfernt werden (siehe z.B. J. March, Advanced Organic Chemistry, 3. Aufl. McGraw-Hill, S. 510).

Die erfindungsgemäßen Polymere können als Elektrolumineszenzmaterialien Verwendung finden.

Gegenstand der Erfindung ist daher auch die Verwendung von Polymeren der Formel (I) als Elektrolumineszenzmaterial.

Als Elektrolumineszenzmaterial im Sinne der Erfindung gelten Stoffe, die als aktive Schicht in einer Elektrolumineszenzvorrichtung Verwendung finden können. Aktive Schicht bedeutet, da8 die Schicht befähigt ist, bei Anlegen eines elektrischen Feldes Licht abzustrahlen (lichtemittierende Schicht) und/oder daß sie die Injektion und/oder den Transport der positiven und/oder negativen Ladungen verbessert (Ladungsinjektions- oder Ladungstransportschicht). Hervorzuheben sind die hervorragenden Lochleitereigenschaften der erfindungsgemäßen Materialien, die z.B. als Lochtransportschicht Anwendung in Photokopierern und Laserdruckern finden können.

Gegenstand der Erfindung ist daher auch ein Elektrolumineszenzmaterial, enthaltend ein oder mehrere Polymere der Formel (I).

Üblicherweise enthält das erfindungsgemäße Elektrolumineszenzmaterial ein oder mehrere Polymere der Formel (I) als Hauptkomponente, d.h. zu größer als 50 Gew.-%, oder als Additiv.

Um als Elektrolumineszenzmaterialien Verwendung zu finden, werden die Lösungen der Polymere der Formel (I) im allgemeinen nach bekannten, dem Fachmann geläufigen Methoden, wie Gießen (Casting), Eintauchen (Dipping), Aufschleudern (Spincoating) oder Vorhangbeschichtung in Form eines Films auf ein Substrat aufgebracht.
Weiterhin Gegenstand der Erfindung ist daher auch ein Verfahren zur Herstellung eines Elektrolumineszenzmaterials, dadurch gekennzeichnet, da8 man ein Polymer der Formel (I) in Form eines Films auf ein Substrat aufbringt.

Gegenstand der Erfindung ist zudem eine Elektrolumineszenzvorrichtung mit einer oder mehreren aktiven Schichten, wobei mindestens eine dieser aktiven Schichten ein oder mehrere erfindungsgemäße Polymere der Formel (I) enthält. Die aktive Schicht kann beispielsweise eine lichtemittierende Schicht und/oder eine Transportschicht und/oder eine Ladungsinjektionsschicht sein.

Der allgemeine Aufbau solcher Elektrolumineszenzvorrichtungen ist beispielsweise in US 4,539,507 und US 5,151,629 beschrieben. Polymere enthaltende Elektrolumineszenzvorrichtungen sind beispielsweise in WO 90/13148 oder EP-A-0 443861 beschrieben.

Sie enthalten üblicherweise eine elektrolumineszierende Schicht zwischen einer Kathode und einer Anode, wobei mindestens eine der Elektroden transparent ist. Zusätzlich kann zwischen der elektrolumineszierenden Schicht und der Kathode eine Elektroneninjektions- und/oder Elektronentransportschicht eingebracht sein und/oder zwischen der elektrolumineszierenden Schicht und der Anode eine Lochinjektions- und/oder Lochtransportschicht eingebracht sein. Als Kathode können z.B. Ca, Mg, Al, In, Mg/Ag dienen. Als Anode können z.B. Au oder ITO (Indiumoxid/Zinnoxid) auf einem transparentem Substrat, z.B. aus Glas oder einem transparenten Polymer, dienen.

Im Betrieb wird die Kathode auf negatives Potential gegenüber der Anode gesetzt. Dabei werden Elektronen von der Kathode in die Elektroneninjektionsschicht/Elektronentransportschicht bzw. direkt in die lichtemittierende Schicht injiziert. Gleichzeitig werden Löcher von der Anode in die Lochinjektionsschicht/ Lochtransportschicht bzw. direkt in die lichtemittierende Schicht injiziert.

Die injizierten Ladungsträger bewegen sich unter dem Einfluß der angelegten Spannung durch die aktiven Schichten aufeinander zu. Dies führt an der Grenzfläche zwischen Ladungstransportschicht und lichtemittierender Schicht bzw. innerhalb der lichtemittierenden Schicht zu Elektronen/Loch-Paaren, die unter Aussendung von Licht rekombinieren.
Die Farbe des emittierten Lichtes kann durch die als lichtemittierende Schicht verwendete Verbindung variiert werden, wobei ausdrücklich neben Copolymeren auch Abmischungen der erfindungsgemäßen Polymere mit anderen elektrooptischaktiven oder -passiven Stoffen miteingeschlossen sein sollen.

Elektrolumineszenzvorrichtungen finden Anwendung z.B. als selbstleuchtende Anzeigeelemente, wie Kontrollampen, alphanumerische Displays, Hinweisschilder, und in optoelektronischen Kopplern. Die erfindungsgemäßen Materialien sind aufgrund ihrer guten Lochtransporteigenschaften auch als Fotoleiterelemente, z.B. in Fotokopierern und Laserdruckern geeignet.

Die Erfindung wird durch die Beispiele näher erläutert, ohne sie dadurch beschränken zu wollen.

### Beispiele

Die Beispiele 1 bis 11 beschreiben die Synthese von Vorstufen und Edukten. Die Beispiele 12 bis 17 dienen zur Erläuterung der Efindung.

### Beispiel 1: 2,2'-Dilithiobiphenyl

Zu einer eisgekühlten, kräftig gerührten Lösung von 4,0 g (12,9 mmol) 2,2-Dibrombiphenyl in 40 ml absolutem Diethylether (Ether) wurde innerhalb von 5 Minuten 26 ml einer Lösung von 28 mmol n-BuLi in Ether zugetropft und anschlie8end 5 Stunden bei Raumtemperatur nachgerührt.

### Beispiel 2: Bis-(biphenyl-2,2'-diyl)-silan (9,9'-Spirobi-9-sila-fluoren)

Eine gemäß Beispiel 1 hergestellte Lösung von 24 mmol 2,2'-Dilithiobiphenylen in 70 ml Ether wurde innerhalb einer Stunde zu einer kräftig gerührten Lösung von 1,87 g (11 mmol) Siliciumtetrachlorid in 30 ml Ether zugetropft. Die Mischung wurde weitere 1,5 Stunden bei Raumtemperatur gerührt und 3Stunden am Rückfluß gekocht. Anschlie8end wurden 50 ml Benzol zugesetzt und die Mischung 2 weitere Stunden Rückfluß gekocht. Nach Ausschütteln mit 100 ml Wasser wurde die organische Phase über Magnesiumsulfat getrocknet, filtriert und der größte Teil des Ethers am Rotavapor abdestilliert. Aus der abgekühlten Lösung wurden 1,45 g Rohprodukt mit Fp. 222 bis 225EC isoliert. Das Filtrat ergab nach dem Einengen weitere 0,6 g (Gesamtausbeute 56 %). Kristallisation aus Ethanol ergibt ein Produkt mit einem Schmelzpunkt von 227°C.

| Elementaranalyse | % | C | H | Si |
|---|---|---|---|---|
| | Ber. | 86,72 | 4,85 | 8,44 |
| | Gef. | 86,86 | 4,98 | 8,33 |

Die bemerkenswert hohe Stabilität dieser Verbindung zeigt sich am Siedepunkt von 460°C, der ohne sichtbare Zersetzung erreicht wird.

### Beispiel 3: Bis-(biphenyl-2,2'-diyl)-german (9,9'-Spirobi-9-germa-fluoren)

Eine Lösung von 50 mmol 2,2'-Dilithiobiphenyl hergestellt in 140 ml Ether, gemäß Beispiel 1, wurde gemäß Beispiel 2 mit 5,35 g (25 mmol) Germaniumtetrachlorid umgesetzt. Nach Aufarbeitung und Umkristallisation aus Ethylacetat wurden 2,77 g (29 %) Produkt erhalten. Weiße Prismen, Schmelzpunkt 245°C, Siedepunkt 470°C ohne Zersetzung.

| Elementaranalyse | % | Ge |
|---|---|---|
| | Ber. | 19,23 |
| | Gef. | 18,88 |

### Beispiel 4: Biphenyl-2,2'-diyl-siliciumdichlorid

78 mmol 2,2'-Dilithiobiphenyl hergestellt in 230 ml Ether, gemäß Beispiel 1, wurde gemäß Beispiel 2 mit 252 g (1,48 mol, d.h. 18-facher Überschu8) Siliciumtetrachlorid umgesetzt. Nach Abdestillieren des überschüßigen SiCl₄ und Aufarbeitung, wurden 3,5 g eines festen Produkts erhalten, das nach Umkristallisieren aus Ethylacetat 2,89 g (22 %) Bis-(biphenyl-2,2'-diyl)silan, gemäß Beispiel 2, ergab. Die gesammelten Mutterlaugen wurden eingeengt und das zurückbleibende Öl bei 0,01 mbar destilliert, wobei als Vorlauf eine kleine Menge Biphenyl und als Hauptfraktion bei 108 bis 110°C 7,41 g (38 %) Biphenyl-2,2'-diyl-siliciumdichlorid übergingen.

| Elementaranalyse | % | Cl | Si |
|---|---|---|---|
| | Ber. | 28,3 | 11,33 |
| | Gef. | 26,5 | 10,75 |

### Beispiel 5: 10,10-Biphenyl-2,2'-diyl-phenoxasilin [348,48]

Eine Lösung von 120 mmol 2,2'-Dilithio-diphenylether in 180 ml THF, hergestellt gemäß H. Gilman, W. J. Trepka, J. Org. Chem. 1962, 27, 1418, wurde zu einer Lösung von 37,7 g (150 mmol) Biphenyl-2,2'-diyl-siliciumdichlorid, gemäß Beispiel 4, in 200 ml THF gegeben. Man rührte 12 Stunden bei 20EC, hydrolysierte mit einer Mischung aus Eis und Schwefelsäure und extrahierte die wäßrige Phase mit Ether. Nach destillativer Aufarbeitung bei < 0,05 mm wurde die bei 150°C übergehende Hauptfraktion aus Ethanol umkristallisiert. Ausbeute: 12,5 g (30 %).

### Beispiel 6: Bis-(bibenzyl-2,2'-diyl)-silan

Eine Lösung von 2,1 ml (20 mmol) Siliciumtetrachlorid in 50 ml THF wurde zu einer Lösung von 2,2'-Dilithiobibenzyl zugetropft, die zuvor aus 15g (40 mmol) 2,2'-Dibrombibenzyl und 97 mmol einer 1,7 molaren n-Butyllithium in Hexanfraktion bereitet worden war. Es wurde 1 Stunde zum Rückfluß erhitzt und wie in Beispiel 5 aufgearbeitet. Bei 0,05 mm gingen zwischen 125 und 210°C 5,0 g eines erstarrenden Öls über, das nach zweimaliger Kristallisation 1,0 g (13 %) Bis-(bibenzyl-2,2'-diyl)-silan mit Fp. 175°C ergab.

| Elementaranalyse | % | Cl | H |
|---|---|---|---|
| | Ber. | 86,60 | 6,19 |
| | Gef. | 86,21 | 6,05 |

### Beispiel 7: Bis-(stilben-2,2'-diyl)-silan über Bis-(α,α'(β')-dibrombibenzyl-2,2'-diyl)-silan

Eine Aufschlämmung von 1,94 g (5 mmol) Bis(bibenzyl-2,2'-diyl)-silan, hergestellt gemäß Beispiel 6, und 1,78 g (10 mmol) N-Bromsuccinimid in 100 ml Tetrachlormethan wurden unter Bestrahlung mit einer 300 Watt Wolframglühfadenlampe zum Sieden erhitzt. Das gebildete Succinimid wurde abgesaugt, das Filtrat am Rotavapor zur Trockne eingeengt, der Rückstand in 15 ml Toluol aufgenommen und mit 2 ml 2-Dimethylaminoethanol versetzt. Die Mischung wurde 48 Stunden gerührt und dann 6 Stunden zum Sieden erhitzt. Das Toluol wurde im Vakuum entfernt, der Rückstand mit 50 ml 5 gew%-iger Natronlauge versetzt und mit Ether ausgeschüttelt. Nach Trocknung über Magnesiumsulfat wurde der Ether verdampft und der Rückstand in Toluol/Cyclohexan an 30 g Kieselgel chromatographisch gereinigt.

### Beispiel 8: 3,3',6,6'-Tetraphenyl-9-sila-9-spiro-9H-bifluoren über Tetrakis-(biphenylyl-4)-silan

10,8 g (46,3 mmol) 4-Brombiphenyl wurden mit 1,95 g (11,6 mmol) Siliciumtetrachlorid in 100 ml absolutem Ether gelöst und anschlie8end mit 2,5 g (110 mmol) Natrium versetzt. Es wurde bis zum Auflösen des Metalls zum Rückfluß erhitzt und 4 Stunden bei Raumtemperatur nachgerührt. Nach Entfernen des Ethers wurde der Rhckstand mt Toluol in einem Soxhlet extrahiert. Ausbeute: 6,7 g (90 %). Fp. 281°C aus Xylol.

5,4 g (10 mmol) Tetrakis-(biphenylyl-4)-silan wurden in 200 ml 1,2-Dichlorbenzol gelöst und unter Durchleitung von Stickstoff portionsweise mit 6,5 g (40 mmol) Eisen(III)chlorid versetzt. Innerhalb 3 Stunden wurde zum Sieden erhitzt. Als im Abgas keine HCl mehr als NH₄Cl nachweisbar war, wurde am Rotavapor eingeengt, der Rückstand mehrmals mit 5%-iger Salzsäure digeriert und der Rückstand aus Xylol unter Zusatz von 1 g Silicagel umkristallisiert. Ausbeute: 2,7 g (51%).

### Beispiel 9: Biphenyl-2,2-diyl-dibenzosilinan

Bis(2-chlorphenyl)methan wurde entsprechend Chang und Gorey, Organomet. 8, 1890 (1989) hergestellt. 0,1 mol dieser Substanz wurden mit 0,22 mol BuLi gemäß Beispiel 1 lithiiert. Die erhaltene Lösung in Ether wurde zu einer Lösung von 25,1 g (0,1 mol) Biphenyl-2,2'-diyl-siliciumdichlorid, gemäß Beispiel 4, in 150 ml THF getropft. Man rührte 12 Stunden bei Raumtemperatur, hydrolysierte mit einer Mischung aus Eis und Schwefelsäure und extrahierte die wäßrige Phase mit Ether. Nach destillativer Aufarbeitung im Feinvakuum < 0,05 mm Hg wurde die bei ca. 150°C übergehende Hauptfraktion aus Ethanol umkristallisiert. Ausbeute: 13,9 g (40 %).

### Beispiel 10: Biphenyl-2,2'-diyl-dibenzosilinan-9-on

10,4 g (30 mmol) Biphenyl-2,2-diyl-dibenzosilinan, gemäß Beispiel 9, wurden mit einer Lösung von 3,33 g (30 mmol) Selendioxid, gelöst in 22 ml 1,4-Dioxan und 1,4 ml Wasser, versetzt. Danach wurde zum Sieden erhitzt, das abgeschiedene Selen noch heiß filtriert und mit heißem Dioxan extrahiert. Umkristallisation aus i-Propanol ergab 9,9 g Produkt (91 %).

### Beispiel 11: 10,10-(4,4'-Dibrombiphenyl-2,2'-diyl)-dibenzosilinan-9-on

3,6 g (10 mmol) Biphenyl-2,2'-diyl-dibenzosilinan-9-on, gemäß Beispiel 10, wurden in 30 ml Methylenchlorid gelöst und mit 5 mg wasserfreien Eisen(III)chlorid versetzt. Im Dunkeln wurden 1,1 ml (21,2 mmol) Brom gelöst in 5 ml Methylenchlorid, unter Rühren zugetropft. Nach 24 Stunden wurde die braune Lösung mit gesättigter Natriumhydrogencarbonat-Lösung und Wasser gewaschen. Nach Trocknen über MgSO₄ wurde eingeengt und aus Ethanol umkristallisiert. Ausbeute: 3,0 g (58 %).

### Beispiel 12 Polymerisation von 10,10-(4,4'-Dibrombiphenyl-2,2'-diyl)-dibenzosilinan-9-on (Polymer 1)

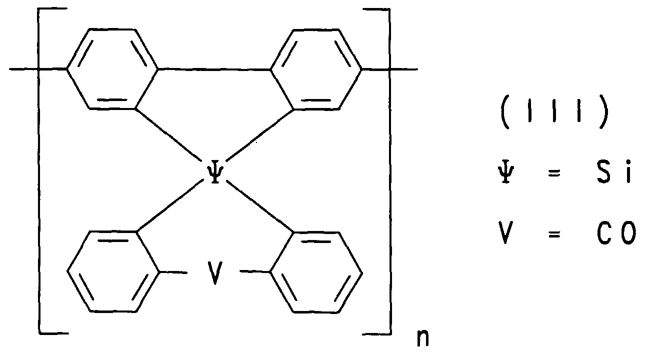

Unter Argon wurde eine Lösung von 1,555 g 10,10-(4,4'-Dibrombiphenyl-2,2'-diyl)-dibenzosilinan-9-on gemäß Beispiel 11 in 30 ml trockenem THF bereitet und auf 60°C erwärmt. Die warme Lösung wurde rasch unter Schutzgas zu einer ebenfalls unter Schutzgas am Rückfluß kochenden Mischung aus 825 mg Ni(cod)₂, 470 mg 2,2'-Bipyridyl und 0,4 ml 1,5-Cyclooctadien (COD) in 20 ml trockenem THF gegeben. Die Polymerisation begann sofort, wobei sich die tiefblaue Reaktionsmischung rot färbte. Man ließ 6 Stunden am Rückfluß weiter kochen und kühlte anschließend auf Raumtemperatur ab. Das rotgefärbte Polymer wurde abgesaugt und mit THF, sowie verdünnten, wäßrigen HCI und Wasser gewaschen.
Durch Extraktion mit 200 ml Chloroform wurde eine erste lösliche Polymerfraktion gewonnen (weitere lösliche Fraktionen sind durch Extraktion z.B. mit 1,2-Dichlorethan und 1-Chlornaphthalin gewinnbar), die durch Ausschütteln mit Ethylendiamintetraessigsäure (3x mit Ammoniak auf pH 7 bis 8 eingestellte wäßrige Lösung, 1x pH 3) und nachfolgendem Ausschütteln mit verdünnter Salzsäure und Wasser gereinigt wird. Die getrocknete Chloroformlösung wurde auf 10 ml eingeengt und das Polymer durch Eintropfen in 70 ml Methanol ausgefällt. Das erhaltene Polymer ist gelblich gefärbt.

### Beispiel 13 Polymerisation von 10,10-(4,4'-Dibrombiphenyl-2,2'-diyl)-bibenzosilinan-9-on mit Biphenyl-4,4'-ylen-diboronsäure (Polymer 2)

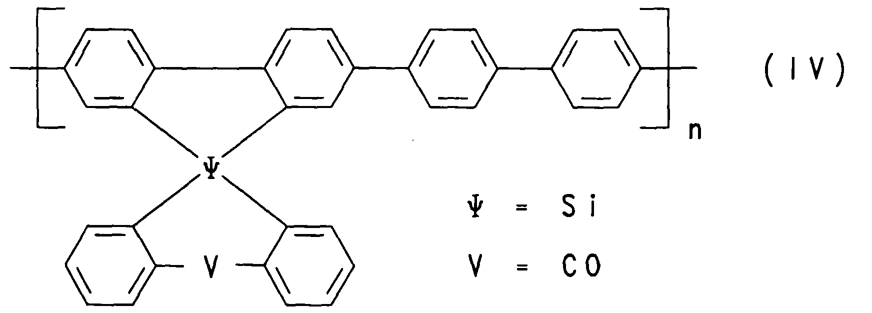

In eine Mischung aus 25 ml THF und 10 ml Ethanol wurden 1,04 g (2 mmol) 10,10-(4,4'-Dibrombiphenyl-2,2'-diyl)-dibenzosilinan-9-on und 483 mg (2 mmol) Biphenyl-4,4'-ylen-diboronsäure gegeben. Dazu wurden 20 ml 1 molare wäßrige Kaliumcarbonatlösung gegeben. Die Mischung wurde unter Stickstoff am Rückfluß gekocht und 50 mg Tetrakis(triphenylphosphino)palladium, gelöst in 5 ml THF wurden zugegeben. Nach 24 Stunden Rückflußkochen wurde auf Raumtemperaur abgekühlt. Das gebildete gelbe Polymer wurde abgesaugt, mit verdünnter Salzsäure 2 Stunden gekocht und nach erneutem Absaugen mit Wasser säurefrei gewaschen. Durch Extraktion mit 100 ml Chloroform wurde eine erste lösliche Polymerfraktion gewonnen (weitere lösliche Fraktionen waren durch Extraktion, z.B. mit 1,2-Dichlorethan und 1-Chlornaphthalin, gewinnbar).

### Beispiel 14

Ausgehend von 2,2'-Dichlordiphenylsulfid wurde analog Beispiel 9 Biphenyl-2,2'-diyl-dibenzo-9-thiasilinan hergestellt, das nach Oxidation mit 3-Chlorperoxybenzoesäure Biphenyl-2,2'-diyl-dibenzo-9-thiasilinan-9,9-dioxid ergab. Dessen Bromierung gemäß Beispiel 11 lieferte 10,10-(4,4'-Dibrombiphenyl-2,2'-diyl-dibenzo-9-thiasilinan-9,9-dioxid), das sich gemäß Beispiel 12 zu Polymer 3 (Formel III mit V = -SO₂-) und gemäß Beispiel 13 zu Polymer 4 (Formel IV mit V = -SO₂-) umsetzen ließ.

### Beispiel 15 Photolumineszenzmessung an Polymer 1

Eine Lösung des Polymers 1 in Chloroform (5 mg/ml) wurde durch Spin-Coating bei 1000 upm auf einen Quarzträger aufgebracht. Bei Anregung mit Licht einer Wellenlänge < 400 nm zeigte der Polymerfilm homogene blaue Fluoreszenz. Das Fluoreszenzspektrum (Spektrofluorimeter Hitachi F4500, Anregung bei 360 nm) des so hergestellten festen Polymerfilms im Vergleich mit dem Fluoreszenzspektrum in verdünnter Lösung (< 10⁻⁴ mol/L in Chloroform) ergab für den Film eine bathochrome Verschiebung um 10 nm unter Beibehalt der spektralen Charakteristik der verdünnten Lösung.

### Beispiel 16 Photolumineszenzmessung an Polymer 2

Eine Lösung des Polymers 2 in Chloroform (5 mg/ml) wurde durch Spin-Coating bei 1000 upm auf einen Quarzträger aufgebracht. Bei Anregung mit Licht einer Wellenlänge < 400 nm zeigte der Polymerfilm homogene blaue Fluoreszenz. Das Fluoreszenzspektrum (Spektrofluorimeter Hitachi F4500, Anregung bei 360 nm) des so hergestellten festen Polymerfilms ergibt im Vergleich mit dem Fluoreszenzspektrum in verdünnter Lösung (< 10⁻⁴ mol/L in Chloroform) für den Film eine bathochrome Verschiebung um 15 nm unter Beibehalt der spektralen Charakteristik der verdünnten Lösung.

### Beispiel 17 Elektrolumineszenz-Vorrichtung

Eine Lösung des zu vermessenden Polymers in Chloroform (Konzentration: 15 mg/ml) wurde unter Stickstoff durch Spin-Coating bei 1000 upm auf einen mit ITO (Indium-Zinn-Oxid) beschichteten Glasträger (strukturiert, Streifen 2 mm breit) aufgebracht. Der Glasträger wurde über eine Schleuse unter Beibehaltung der Schutzgasatmosphäre in eine Hochvakuum-Bedampfungsanlage überfhhrt. Bei 2x10⁻⁵ mbar wurden quer zu den ITO-Streifen unter Verwendung einer Maske Ca-Streifen (2 mm breit, 230 nm dick) auf die Polymerschicht aufgedampft. Die so erhaltene Vorrichtung, ITO/Polymer/Ca, wurde in einen Probenhalter gegeben und die Elektroden über Federkontakte mit einer Stromquelle verbunden, wobei ein ITO-Streifen positiv und ein Ca-Streifen negativ gepolt wurden. Beim Anlegen einer Spannung von 20 V wurde an dem entsprechenden Matrixelement eine blaue Elektrolumineszenz beobachtet.

## Patentansprüche

1. Konjugiertes Polymer, enthaltend Wiederholeinheiten der Formel (I), 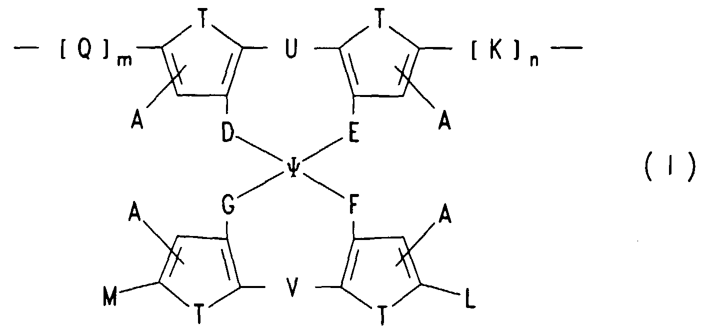 wobei die Symbole und Indizes folgende Bedeutungen haben:
Ψ ist ein Element der 4. Hauptgruppe des Periodensystems mit Ausnahme von Kohlenstoff;
D, E, F, G sind gleich oder verschieden, -CR¹R²-, -O-, -S-, -NR³- oder eine chemische Bindung;
wobei R¹, R², R³ gleich oder verschieden, eine geradkettige oder verzweigte Alkyl, Alkoxy oder Estergruppe mit 1 bis 22 C-Atomen, Aryl- und/oder Aryloxygruppen, wobei der Aromat mit C₁-C₂₂-Alkyl, C₁-C₂₂-Alkoxy, Br, Cl, F, CN, und/oder NO₂ substituiert sein kann, Br, Cl, F, CN, NO₂ oder CF₃, oder H bedeuten oder wobei R¹ und R² gemeinsam einen gegebenenfalls substituierten Ring bilden können;
U ist -CR⁴=CR⁵- oder eine chemische Bindung;
V hat die Bedeutung von U oder ist -CR¹R²-, -O-, -S-, -NR³-, -SiR¹R²-, -SO₂-,-SO-, -CO-,
wobei R¹, R², R³ die oben angegebene Bedeutung haben und R⁴ R⁵ gleich oder verschieden die gleichen Bedeutungen wie R¹, R², R³ haben;
A ist gleich oder verschieden H, eine geradkettige oder verzweigte Alkyl, Alkoxy oder Estergruppe mit 1 bis 22 C-Atomen, Aryl- und/oder Aryloxygruppen, wobei der Aromat mit C₁-C₂₂-Alkyl, C₁-C₂₂-Alkoxy, Br, Cl, F, CN, und/oder NO₂ substituiert sein kann, Br, Cl, F, CN, NO₂ oder CF3;
T ist -O-, -S-, -NR³-, -CR¹R²-, -CH=N-, -CA=CA-, -CH=CA-, -CH=CF- oder-CF=CF-, wobei R¹, R², R³ und A die oben angegebene Bedeutungen haben;
K, Q sind gleich oder verschieden Kohlenwasserstoffreste, die
Heteroatome enthalten können und durch konjugierte Elektronensysteme gekennzeichnet sind; wobei K und Q auch mit den jeweils ortho-stehenden Gruppen A zu einem Ring zusammengeschlossen sein können, der gesättigt, partiell ungesättigt oder maximal ungesättigt ist;
L, M sind gleich oder verschieden Wasserstoff, Kohlenwasserstoffreste, die Heteroatome enthalten können und durch konjugierte Elektronensysteme gekennzeichnet sind; wobei L und M auch mit den jeweils ortho-stehenden Gruppen A zu einem Ring zusammengeschlossen sein können, der gesättigt, partiell ungesättigt oder maximal ungesättigt ist.
m, n sind gleich oder verschieden 0, 1, 2, 3, 4.

2. Polymer nach Anspruch 1, dadurch gekennzeichnet, daß es 2 bis 1000 Wiederholeinheiten aufweist.

3. Polymer nach Anspruch 1 enthaltend Wiederholeinheiten der Formel (II), 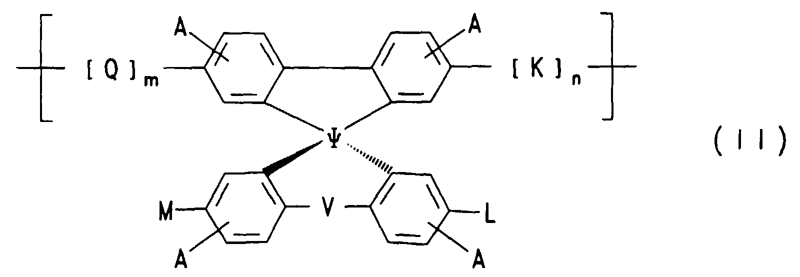 wobei die Symbole und Indizes folgende Bedeutungen haben:
Ψ ist Sn, Ge oder Si;
Q und K sind gleich oder verschieden jeweils eine bis fünfzehn gleiche oder verschiedene Arylen- und/oder Heteroarylen- und/oder Vinylengruppen, die gegebenenfalls substituiert sein können;
L und M sind gleich oder verschieden Wasserstoff, jeweils eine bis fünfzehn gleiche oder verschiedene Arylen- und/oder Heteroarylen- und/oder Vinylengruppen, die gegebenenfalls substituiert sein können;
A ist gleich oder verschieden ein Substituent und hat die gleichen Bedeutungen wie in der Formel (I) in Anspruch 1;
m, n sind 0 oder 1.

4. Polymer nach Anspruch 3, dadurch gekennzeichnet, daß die Symbole und Indizes in der allgemeinen Formel (II) folgende Bedeutungen haben:
A ist gleich oder verschieden R¹, R², R³ und/oder R⁴;
Q, K sind gleich oder verschieden 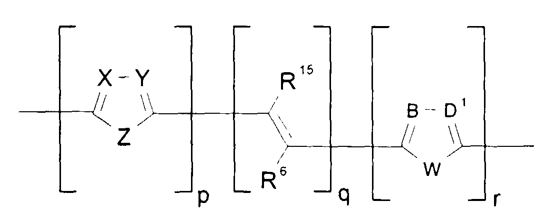 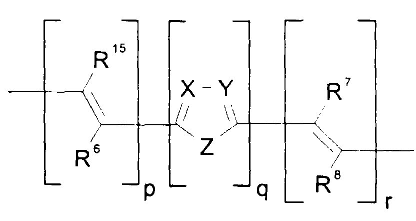 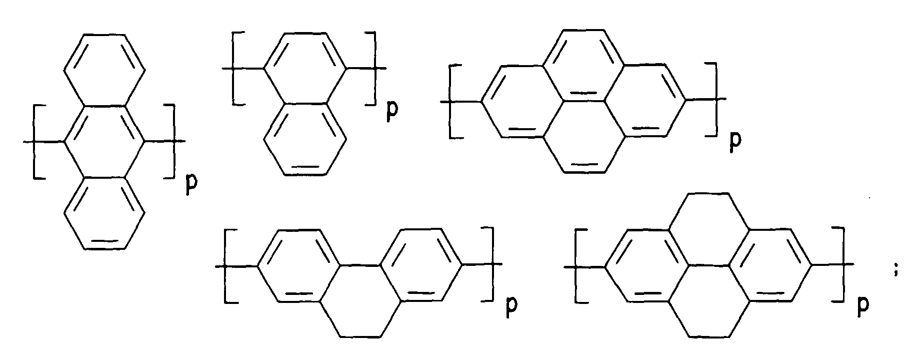
X, Y, B, D¹ sind gleich oder verschieden CR⁵, N;
Z, W sind gleich oder verschieden O, S, NR⁵, CR⁵R⁶, -CR⁵=CR⁶-, -CR⁵=N-;
p, q, r sind gleich oder verschieden 0, 1 bis 5;
R¹, R², R³, R⁴, R⁵, R⁶, R⁷, R⁸, R¹⁵ sind gleich oder verschieden H, eine geradkettige oder verzweigte Alkyl, Alkoxy oder Estergruppe mit 1 bis 22 C-Atomen, Aryl- und/oder Aryloxygruppen, wobei der Aromat mit C₁-C₂₂-Alkyl, C₁-C₂₂-Alkoxy, Br, Cl, F, CN, und/oder NO₂ substituiert sein kann, Br, Cl, F, CN, NO₂ oder CF₃;
L, M sind gleich oder verschieden Wasserstoff, 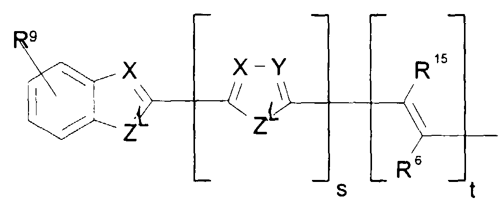 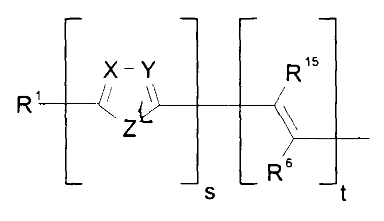 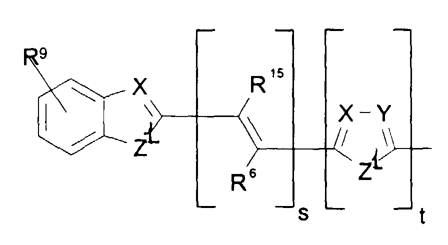 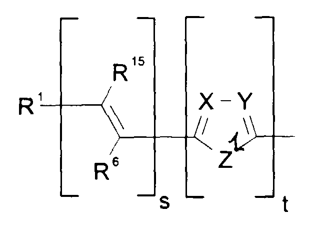 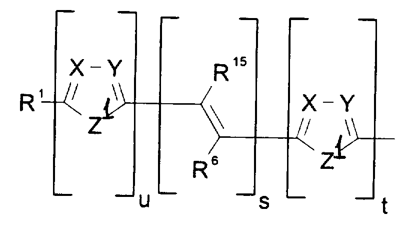 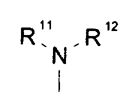 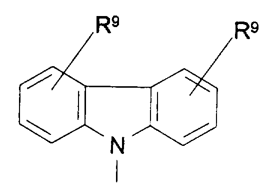
R⁹ ist gleich oder verschieden H, eine unverzweigte oder verzweigte Alkyl- oder Alkoxygruppe mit 1 bis 22 Kohlenstoffatomen, -CN, -NO₂, -NR¹¹R¹², Phenyl, Biphenyl, 1-Naphthyl, 2-Naphthyl, 2-Thienyl, 2-Furanyl, wobei Aryle und Heteroaryle einen weiteren Substituenten R⁹ tragen können;
X, Y sind gleich oder verschieden =CR⁵-, =N-;
Z¹ ist gleich oder verschieden -O-, -S-, -NR¹¹-, CR⁵R⁶, -CR⁵=CR⁶-, -CR⁵=N-;
R¹¹, R¹² sind gleich oder verschieden H, eine unverzweigte oder verzweigte Alkylgruppe mit 1 bis 22 Kohlenstoffatomen, Phenyl, 3-Methylphenyl, Biphenyl, 1-Naphthyl, 2-Naphthyl.

5. Polymer nach Anspruch 3, dadurch gekennzeichnet, daß die Symbole und Indizes in der Formel (II) folgende Bedeutungen haben:
Q, K sind gleich oder verschieden 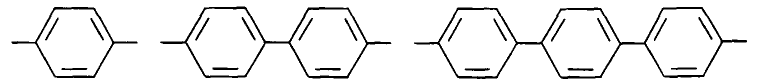 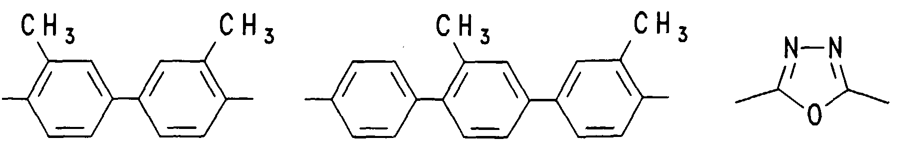 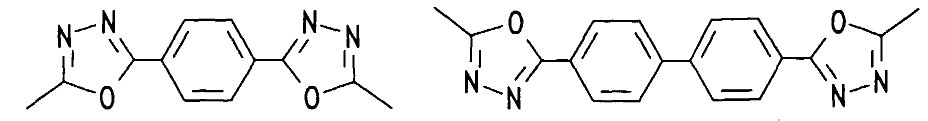 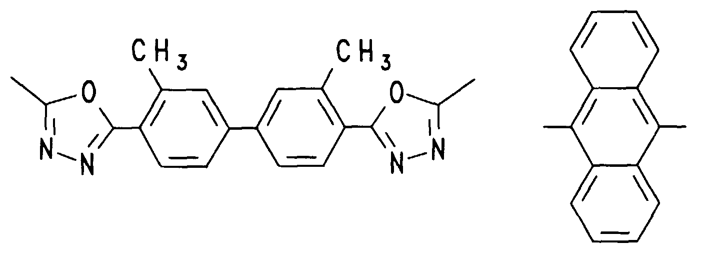
m, n sind gleich oder verschieden 0 oder 1;
L, M sind gleich oder verschieden, Wasserstoff, 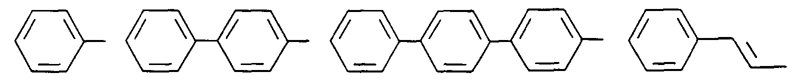 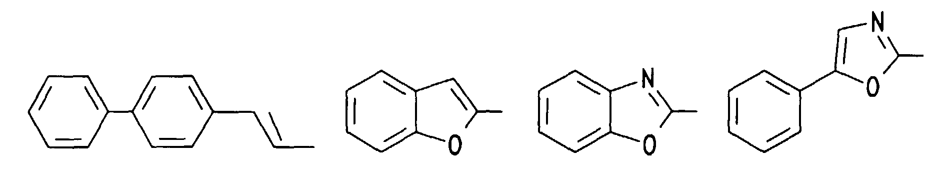 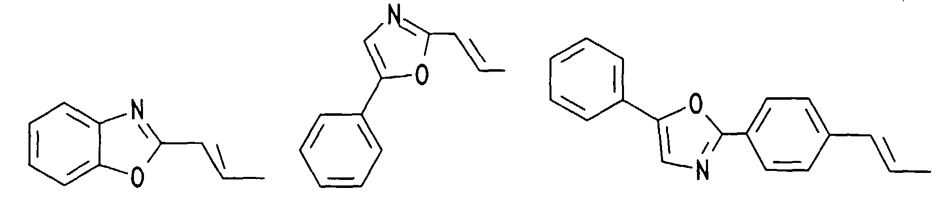 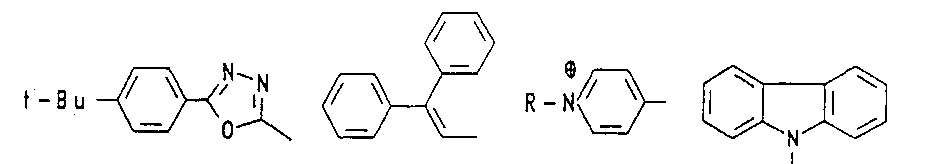
R = C₁-C₂₂-Alkyl, C₂H₄SO₃⁻

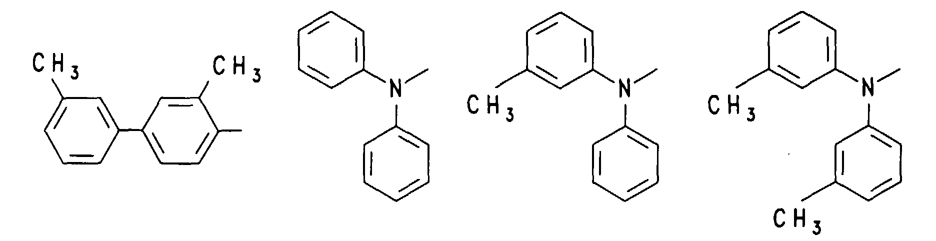

6. Polymer nach Anspruch 3, dadurch gekennzeichnet, daß die Symbole und Indizes in der Formel (II) folgende Bedeutungen haben:
Q, K sind gleich oder verschieden 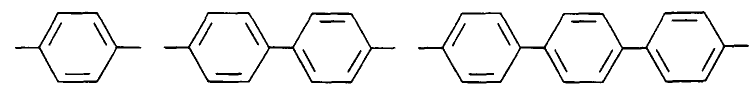 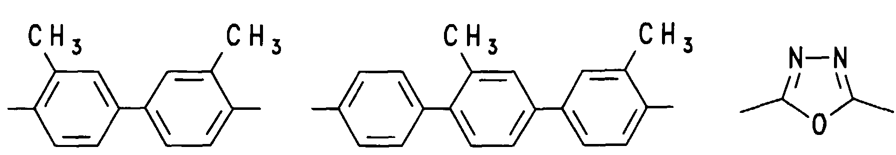 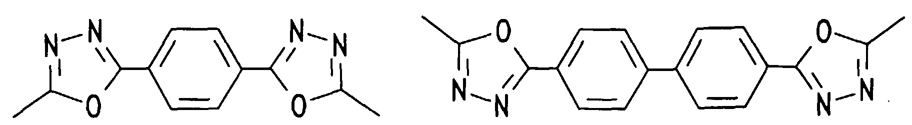 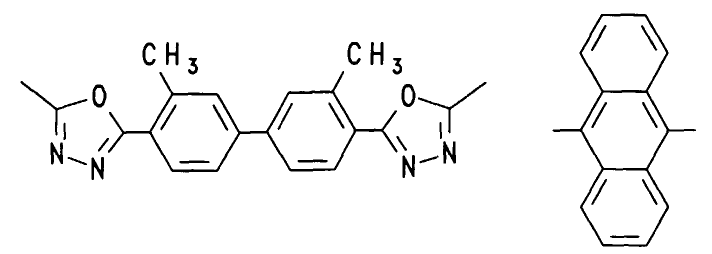
m + n ist 0 oder 1;
L, M sind gleich oder verschieden, Wasserstoff,

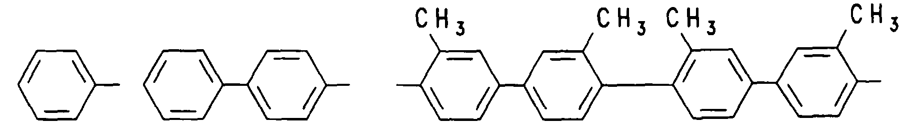

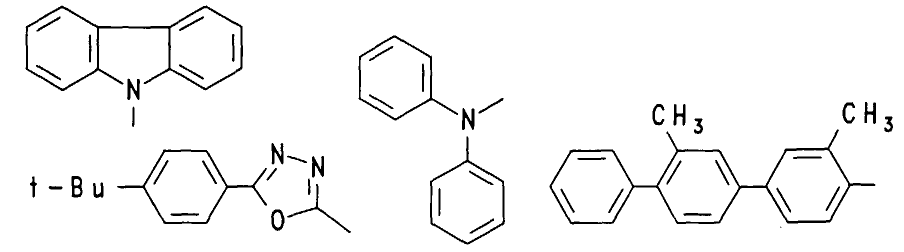

7. Polymer nach Anspruch 1, dadurch gekennzeichnet, daß es ein Copolymer ist.

8. Verwendung eines Polymeren nach einem oder mehreren der Ansprüche 1 bis 7 als Elektrolumineszenzmaterial.

9. Elektrolumineszenzmaterial, enthaltend ein Polymer nach einem oder mehreren der Ansprüche 1 bis 7.

10. Verfahren zur Herstellung eines Elektrolumineszenzmaterials, dadurch gekennzeichnet, daß ein Polymer nach einem oder mehreren der Ansprüche 1 bis 7 in Form eines Films auf ein Substrat aufgebracht wird.

11. Elektrolumineszenzvorrichtung mit einer oder mehreren aktiven Schichten, dadurch gekennzeichnet, daß mindestens eine dieser aktiven Schichten ein Polymer gemäß einem oder mehreren der Ansprüche 1 bis 7 als Elektrolumineszenzmaterial enthält.

## Claims

1. A conjugated polymer comprising recurring units of the formula (I), 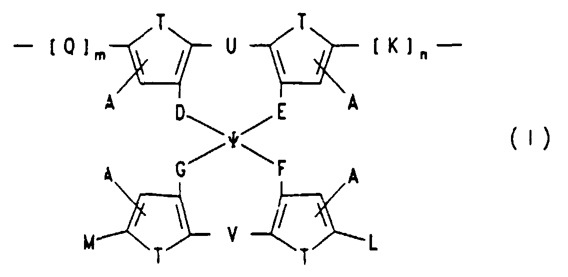 where the symbols and indices have the following meanings:
Ψ is an element of the 4th main group of the Periodic Table with the exception of carbon;
D, E, F, G are identical or different and are each -CR¹R²-, -O-, -S-, -NR³- or a chemical bond;
where R¹, R², R³ are identical or different and are each a straight-chain or branched alkyl, alkoxy or ester group having from 1 to 22 carbon atoms, aryl and/or aryloxy groups, where the aromatic ring may be substituted by C₁-C₂₂-alkyl, C₁-C₂₂-alkoxy, Br, Cl F, CN and/or NO₂, or are Br, Cl, F, CN, NO₂ or CF₃, or H or where R¹ and R² together can form an unsubstituted or substituted ring;
U is -CR⁴=CR⁵- or a chemical bond;
V is as defined for U or is -CR¹R²-, -O-, -S-, -NR³ -, -SiR¹R²-, -S^{O2}-, -SO- or -CO-,
where R¹, R², R³ are as defined above and R⁴, R⁵ are identical or different and are as defined for R¹, R² and R³;
A are identical or different and are H, a straight-chain or branched alkyl, alkoxy or ester group having from 1 to 22 carbon atoms, aryl and/or aryloxy groups, where the aromatic ring may be substituted by C₁-C₂₂-alkyl, C₁⁻C₂₂-alkoxy, Br, Cl F, CN and/or NO₂, or are Br, Cl, F, CN, NO₂ or CF₃,
T is -O-, -S-, -NR³ - , -CR¹R²-, -CH=N-, -CA=CA-, -CH=CA-, -CH=CF- or -CF=CF-, where R¹, R², R³ and A are as defined above;
K and Q are identical or different and are hydrocarbon radicals, which may contain heteroatoms and have conjugated electron systems; where K and Q can also be joined to the groups A in the respective ortho positions to form a ring which is saturated, partially unsaturated or has maximum unsaturation;
L and M are identical or different and are hydrogen, hydrocarbon radicals, which may contain heteroatoms and have conjugated electron systems: where L and M can also be joined to the groups A in the respective ortho positions to form a ring which is saturated, partially unsaturated or has maximum unsaturated;
m, n are identical or different and are 0, 1, 2, 3 or 4.

2. A polymer as claimed in claim 1, having from 2 to 1000 recurring units.

3. A polymer as claimed in claim 1 comprising recurring units of the formula (II), 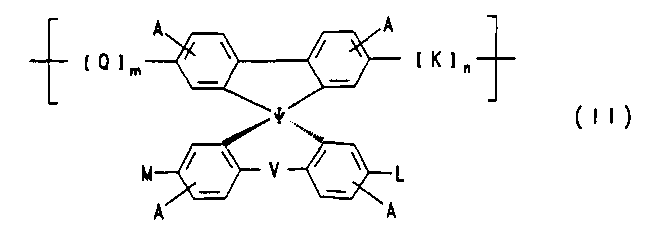 where the symbols and indices have the following meanings:
ψ is Sn, Ge or Si;
Q and K are identical or different and are each from one to fifteen identical or different arylene and/or heteroarylene and/or vinylene groups, which may be unsubstituted or substituted;
L and M are identical or different and are hydrogen or are each from one to fifteen identical or different arylene and/or heteroarylene and/or vinylene groups, which may be unsustituted or substituted;
A are identical or different substituents and are as defined in the formula (I) in claim 1;
m and n are 0 or 1.

4. A polymer as claimed in claim 3, wherein the symbols and indices in the formula (II) have the following meanings:
A are identical or different and are R¹, R², R³ and/or R⁴;
Q, K are identical or different and are 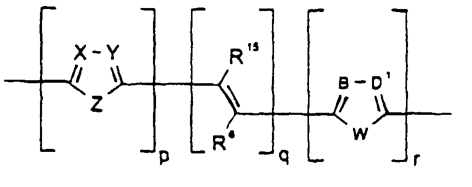 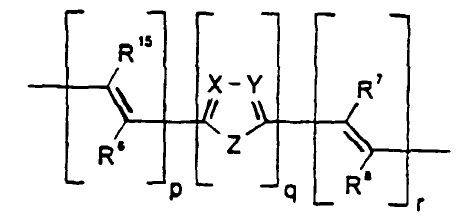 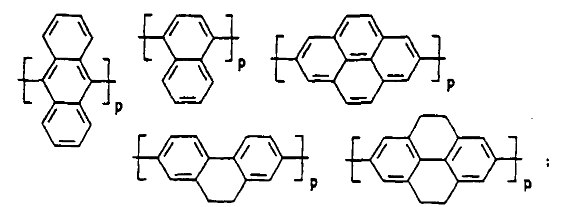
X, Y and B, D¹ are identical or different and are CR⁵, N;
Z and W are identical or different and are O, S, NR⁵, CR⁵R⁶, -CR⁵=CR⁶- or -CR⁵=N-;
p, q and r are identical or different and are 0, 1 to 5;
R¹, R², R³, R⁴, R⁵, R⁶, R⁷, R⁸ and R¹⁵ are identical or different and are each H, a straight-chain or branched alkyl, alkoxy or ester group having from 1 to 22 carbon atoms, aryl and/or aryloxy groups, where the aromatic ring may be substituted by C₁-C₂₂-alkyl, C₁-C₂₂-alkoxy, Br, Cl, F, CN and/or NO₂, or are Br, Cl, F, CN, NO₂ or CF₃;
L, M are identical or different and are hydrogen, 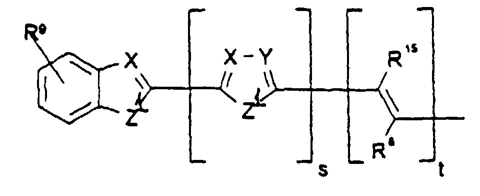 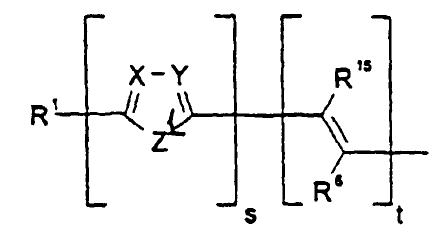 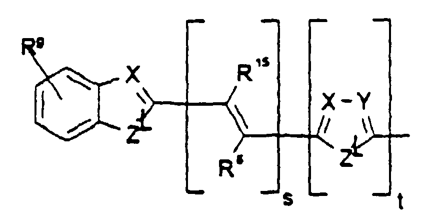 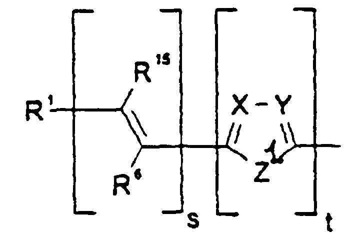 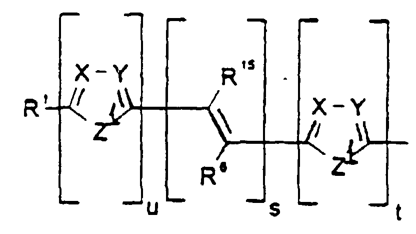 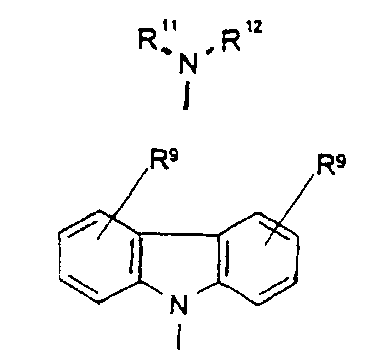
R⁹ are identical or different and are each H, an unbranched or branched alkyl or alkoxy group having from 1 to 22 carbon atoms, -CN, -NO₂, -NR¹¹R¹², phenyl, biphenyl, 1-naphthyl, 2-naphthyl, 2-thienyl or 2-furanyl, where aryls and heteroaryls can bear a further substituent R⁹;
X and Y are identical or different and are =CR⁵- or =N-;
Z¹ are identical or different and are -O-, -S-,-NR¹¹- , CR⁵R⁶, -CR⁵=CR⁶- or -CR⁵=N-;
R¹¹, R¹² are identical or different and are each H, an unbranched or branched alkyl group having from 1 to 22 carbon atoms, phenyl, 3-methylphenyl, biphenyl, 1-naphthyl or 2-naphthyl.

5. A polymer as claimed in claim 3, wherein the symbols and indices in the formula (II) have the following meanings:
Q and K are identical or different and are 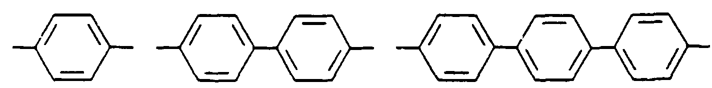 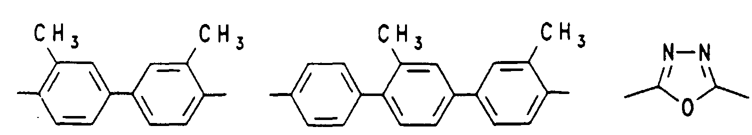 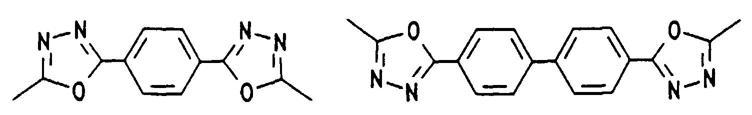 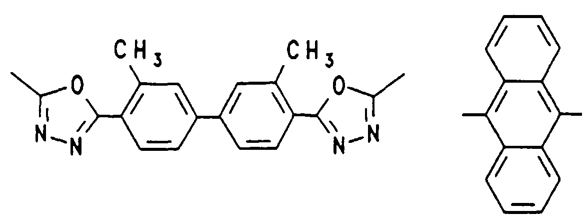
m and n are identical or different and are 0 or 1;
L and M are identical or different and are hydrogen, 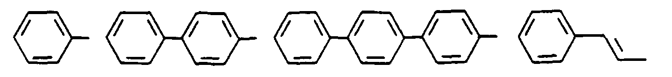 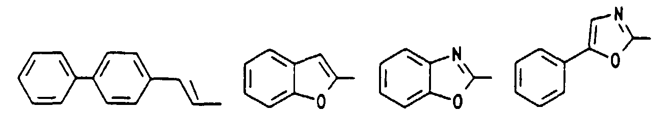 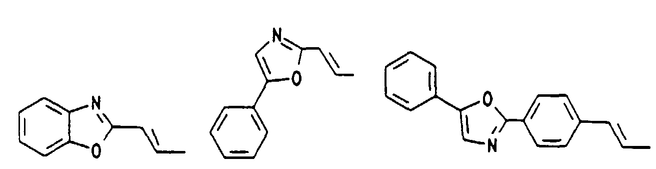 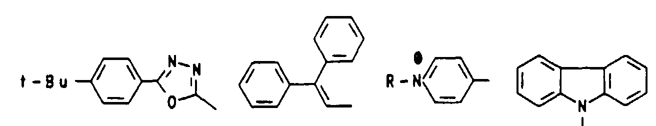
R = C₁-C₂₂-alkyl, C₂H₄SO₃⁻

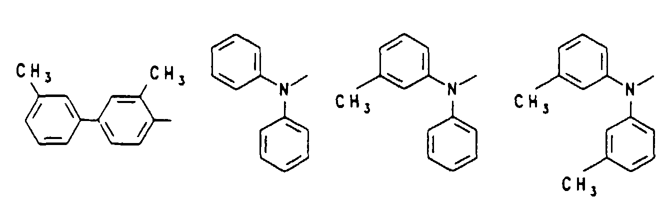

6. A polymer as claimed in claim 3, wherein the symbols and indices in the formula (II) have the following meanings:
Q and K are identical or different and are 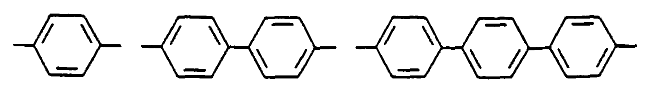 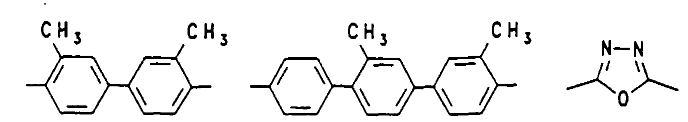 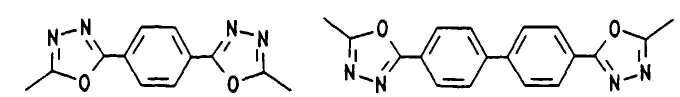 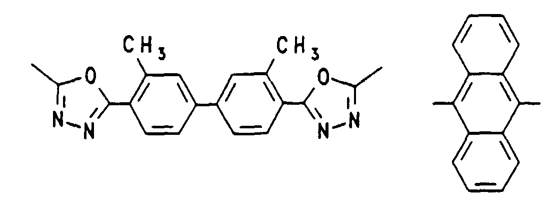
m + n is 0 or 1;
L and M are identical or different and are hydrogen,

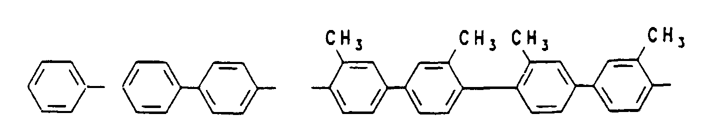

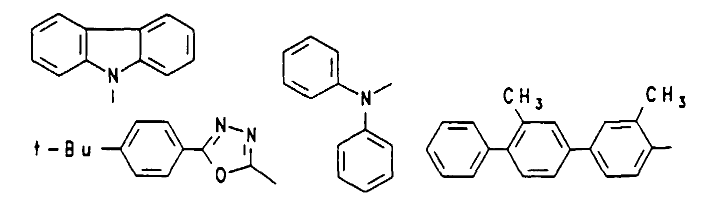

7. A polymer as claimed in claim 1 which is a copolymer.

8. The use of a polymer as claimed in one or more of claims 1 to 7 as an electroluminescent material.

9. An electroluminescent material comprising a polymer as claimed in one or more of claims 1 to 7.

10. A process for producing an electroluminescent material, which comprises applying a polymer as claimed in one or more of claims 1 to 7 in the form of a film to a substrate.

11. An electroluminescent device having one or more active layers, wherein at least one of these active layers comprises a polymer as claimed in one or more of claims 1 to 7 as electroluminescent material.

## Revendications

1. Polymère conjugué, contenant des motifs de répétition de formule (I), 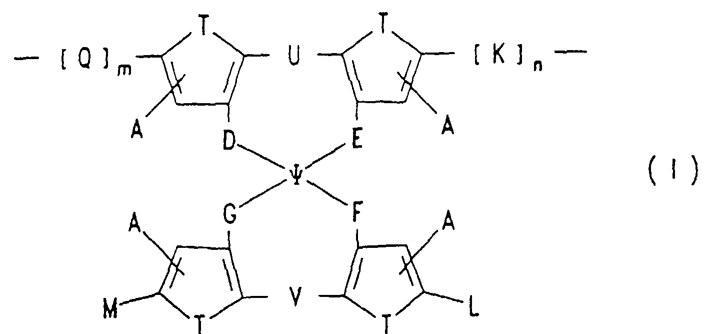 dans laquelle les symboles et indices ont les significations suivantes :
Ψ est un élément du groupe principal 4 de la classification périodique des éléments à l'exception du carbone;
D, E, F, G sont identiques ou différents et représentent -CR¹R², -O-, -S-, -NR³ ou une liaison chimique;
formules dans lesquelles R¹, R², R³, sont identiques ou différents, représentent un groupe alkyle, alcoxy ou ester linéaire ou ramifié ayant 1 à 22 atomes de carbone, des groupes aryle et/ou aryloxy, dans lesquels le groupe aromatique peut être substitué par un groupe alkyle en C₁-C₂₂, alcoxy en C₁-C₂₂, Br, Cl, F, CN, et/ou NO₂, représentent un atome de brome, de chlore, de fluor, un groupe CN, NO₂, CF₃, ou un atome d'hydrogène ou dans lesquelles R¹ et R² peuvent former ensemble un cycle éventuellement substitué;
U est -CR⁴=CR⁵- ou une liaison chimique;
V a la signification de U ou est -CR¹R²-, -O-, -S-, -NR³-, -SiR¹R²-, -SO₂-, -SO-, -CO-,
formules dans lesquelles R¹, R², R³ ont la signification donnée ci-dessus et R⁴, R⁵, identiques ou différents, ont la même signification que R¹, R², R³.
A sont identiques ou différents et représentent un groupe alkyle, alcoxy ou ester linéaire ou ramifié ayant 1 à 22 atomes de carbone, des groupes aryle et/ou aryloxy, dans lesquels le groupe aromatique peut être substitué par un groupe alkyle en C₁-C₂₂, alcoxy en C₁-C₂₂, Br, Cl, F, CN, et/ou NO₂, représentent un atome de brome, de chlore, de fluor, un groupe CN, NO₂ ou CF₃;
T est -O-, -S-, -NR³-, -CR¹R²-, -CH=N-, -CA=CA-, -CH=CA-, -CH=CF- ou -CF=CF-, formules dans lesquelles R¹, R², R³ et A ont les significations indiquées;
K,Q sont des groupes hydrocarbonés identiques ou différents, qui peuvent contenir des hétéroatomes et sont caractérisés par des systèmes électroniques conjugués; K et Q pouvant être refermés en un cycle avec les groupes A respectivement positionnés en ortho, qui est saturé, partiellement insaturé ou insaturé au maximum;
L, M sont identiques ou différents et représentent un atome d'hydrogène, des groupes hydrocarbonés, qui peuvent contenir des hétéroatomes et sont caractérisés par des systèmes électroniques conjugués; L et M pouvant être aussi refermés en un cycle avec les groupes A respectivement positionnés en ortho, qui est saturé, partiellement insaturé ou insaturé au maximum;
m, n sont les nombres identiques ou différents 0, 1, 2, 3, 4.

2. Polymère selon la revendication 1, caractérisé en ce qu'il présente de 2 à 200 motifs de répétition.

3. Polymère selon la revendication 1 contenant des motifs de répétition de formule (II), 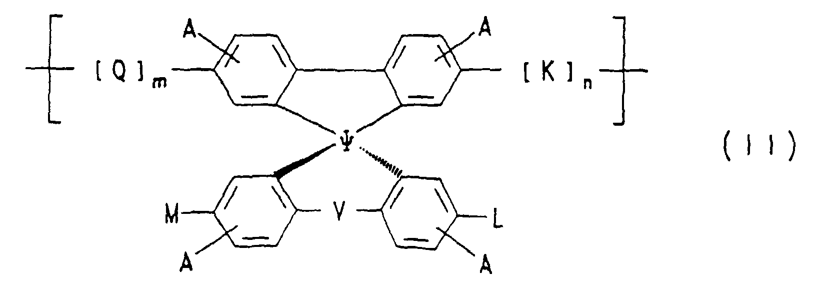 dans laquelle les symboles et indices ont les significations suivantes :
Ψ est Sn, Ge ou Si;
Q et K sont identiques ou différents et représentent respectivement un à quinze groupes arylène et/ou hétéroarylène et/ou vinylène identiques ou différents, qui peuvent être éventuellement substitués;
L et M sont identiques ou différents et représentent un atome d'hydrogène, respectivement un à quinze groupes arylène et/ou hétéroarylène et/ou vinylène identiques ou différents, qui peuvent être éventuellement substitués;
A sont, identiques ou différents, un substituant et ont les mêmes significations que dans la formule (I) de la revendication 1;
m, n sont 0 ou 1.

4. Polymère selon la revendication 3, caractérisé en ce que les symboles et indices dans la formule générale (II) ont les significations suivantes :
A sont identiques ou différents et représentent R¹, R², R³ et/ou R⁴;
Q, K sont identiques ou différents, en particulier 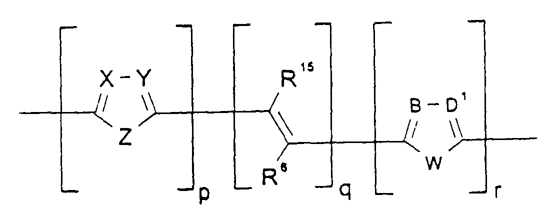 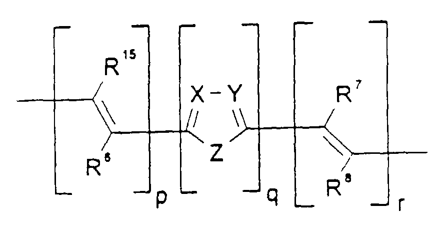 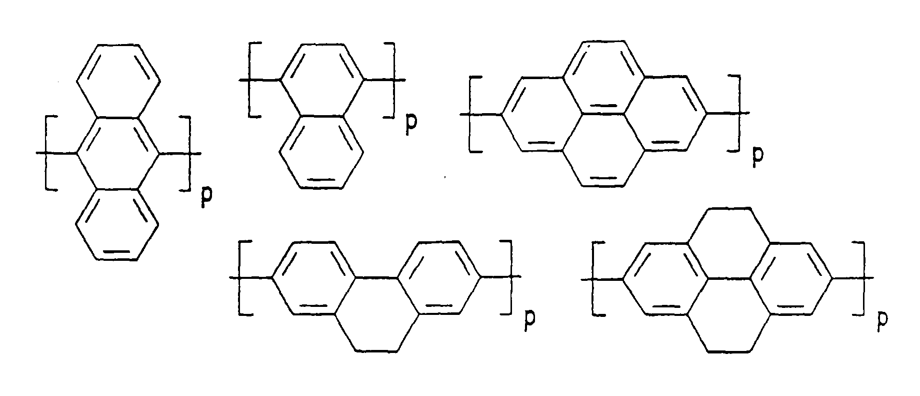
X, Y, B, D¹ sont identiques ou différents et représentent CR⁵, un atome d'azote;
Z, W sont identiques ou différents et représentent O, S, NR⁵, CR⁵R⁶, -CR⁵=CR⁶-, -CR⁵=N-;
p, q, r sont, identiques ou différents, 0, 1 à 5;
R¹, R², R³, R⁴, R⁵, R⁶, R⁷, R⁸, R¹⁵ sont identiques ou différents et représentent un atome d'hydrogène, un groupe alkyle, alcoxy ou ester linéaire ou ramifié ayant 1 à 22 atomes de carbone, des groupes aryle et/ou aryloxy, dans lesquels le groupe aromatique peut être substitué par un groupe alkyle en C₁-C₂₂, alcoxy en C₁-C₂₂, Br, Cl, F, CN, et/ou NO₂, représentent un atome de brome, de chlore, de fluor, un groupe CN, NO₂ ou CF₃;
L, M sont identiques ou différents et représentent un atome d'hydrogène 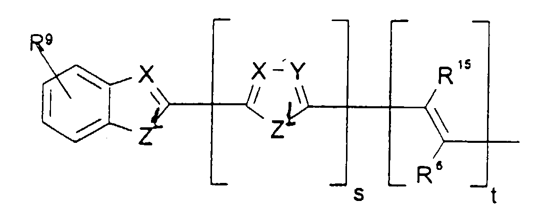 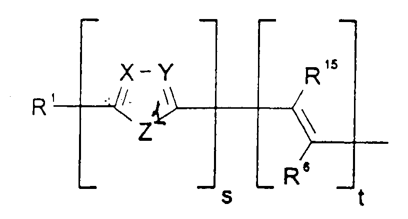 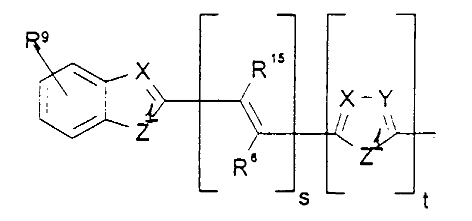 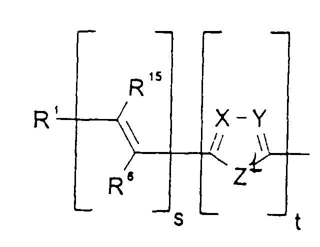 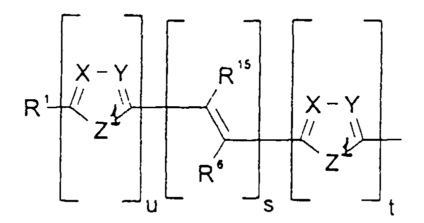 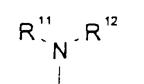 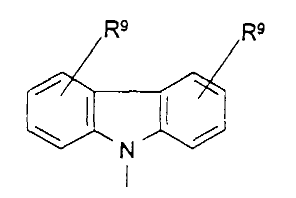
R⁹ sont des groupes identiques ou différents et représentent un atome d'hydrogène, un groupe alkyle, ou alcoxy linéaire ou ramifié ayant 1 à 22 atomes de carbone, -CN, -NO₂, -NR¹¹R¹², phényle, biphényle, 1-napthyle, 2-napthyle, 2-thiényle, 2-furanyle, dans lesquels les groupes aryle et hétéroaryle peuvent porter d'autres substituants R⁹;
X, Y sont identiques ou différents et représentent =CR⁵-, =N-;
Z¹ sont, identiques ou différents, -O-, -S-, -NR¹¹-, -CR⁵R⁶, -CR⁵=CR⁶-, -CR⁵=N-;
R¹¹, R¹² sont des groupes identiques ou différents et représentent un atome d'hydrogène, un groupe alkyle non ramifié ou ramifié ayant 1 à 22 atomes de carbone, phényle, 3-méthylphényle, biphényle, 1-napthyle, 2-napthyle.

5. Polymère selon la revendication 3, caractérisé en ce que les symboles et indices de la formule (II) ont les significations suivantes :
Q, K sont identiques ou différents et représentent 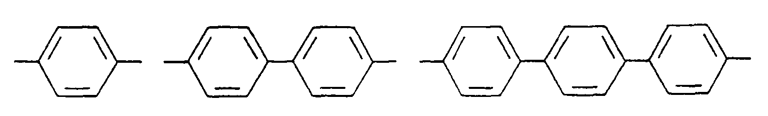 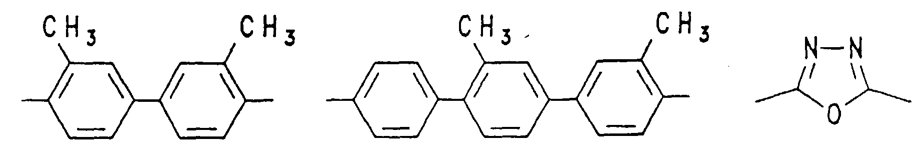 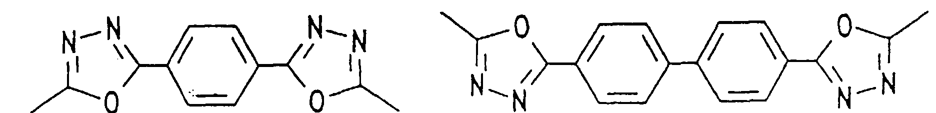 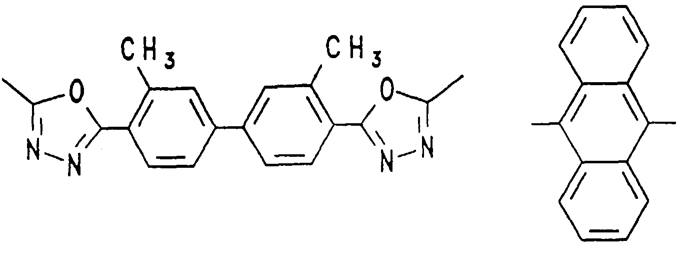
m, n sont identiques ou différents et représentent 0 ou 1;
L, M sont identiques ou différents et représentent un atome d'hydrogène, 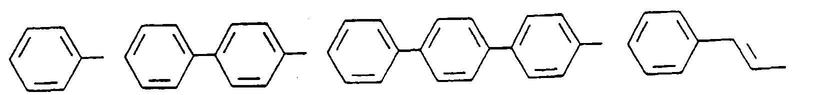 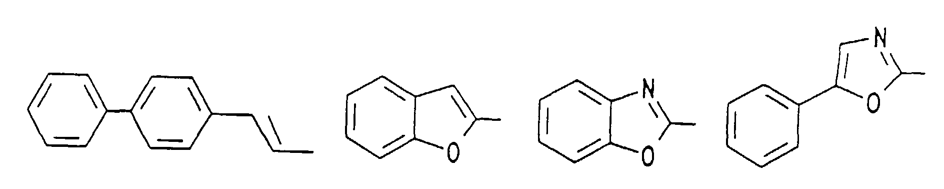 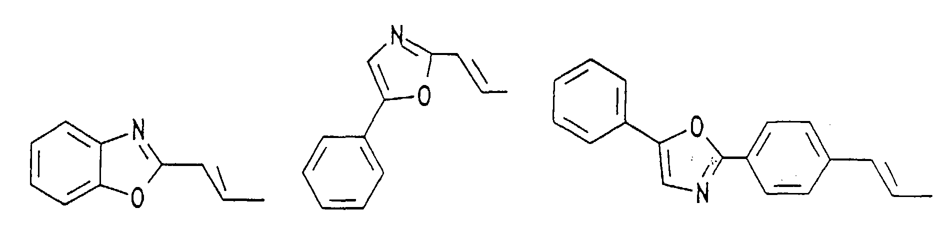 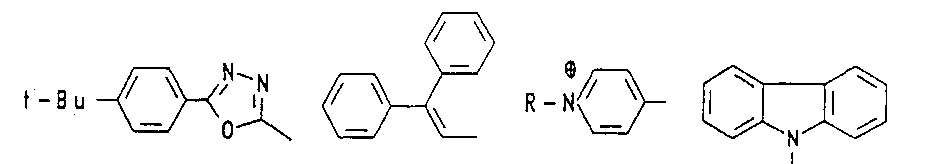
R = alkyle en C₁-C₂₂, C₂H₄SO₃-

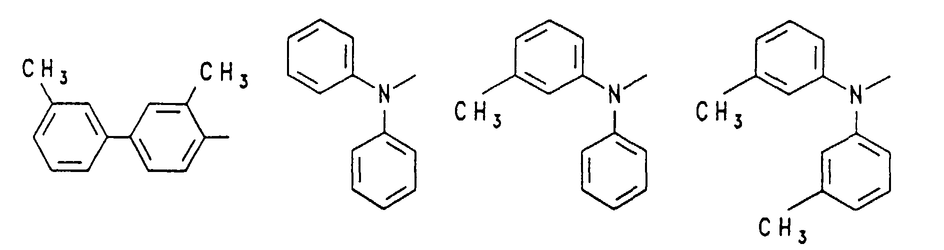

6. Polymère selon la revendication 3, caractérisé en ce que les symboles et indices de la formule (II) ont les significations suivantes :
Q, K sont identiques ou différents et représentent 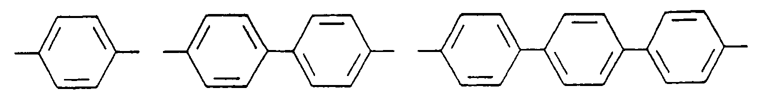 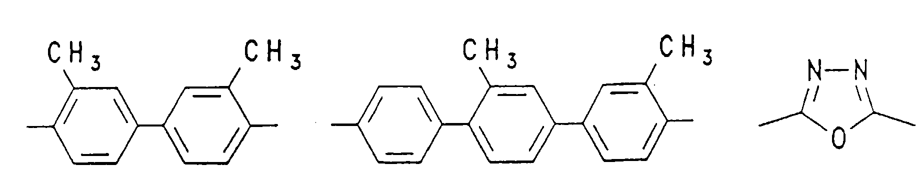 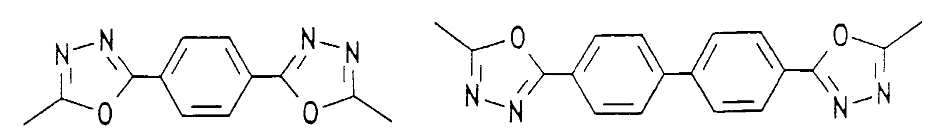 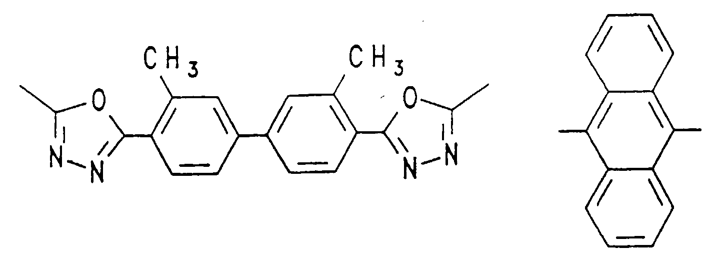
m + n est 0 ou 1;
L, M sont identiques ou différents et représentent un atome d'hydrogène;

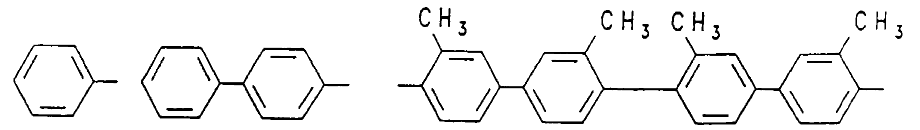

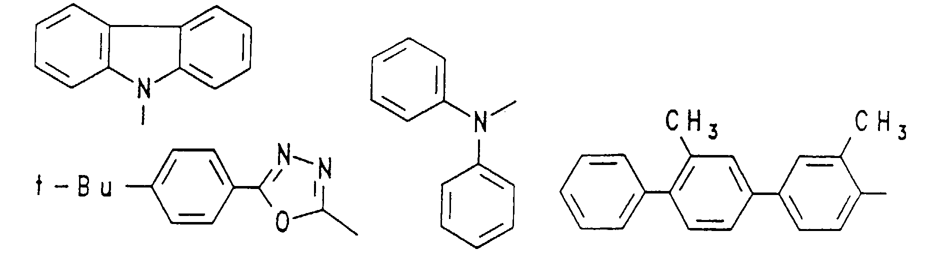

7. Polymère selon la revendication 1, caractérisé en ce qu'il est un copolymère.

8. Utilisation d'un polymère selon une ou plusieurs des revendications 1 à 7 comme matériau électroluminescent.

9. Matériau électroluminescent, contenant un polymère selon une ou plusieurs des revendications 1 à 7.

10. Procédé de préparation d'un matériau électroluminescent, caractérisé en ce que, l'on dépose un polymère selon une ou plusieurs des revendications 1 à 7 sous la forme d'un film sur un substrat.

11. Dispositif électroluminescent avec une ou plusieurs couches actives, caractérisé en ce qu'au moins une de ces couches actives contient comme matériau électroluminescent un polymère selon une ou plusieurs des revendications 1 à 7.
